# EUROPEAN PATENT APPLICATION

(11) **EP 4 557 002 A2**
(43) Date of publication of application: **21.05.2025**
(21) Application number: 24212018.6
(22) Date of filing: 11.11.2024
(51) Int. Cl.: G03F 7/075, G03F 7/09

(54) **PATTERNING PROCESS**

(30) Priority: 20.11.2023 JP 2023196947
(71) Applicant: Shin-Etsu Chemical Co., Ltd., Tokyo 100-0005 (JP)
(72) Inventor: Kobayashi, Naoki, Niigata (JP); Takizawa, Kanata, Niigata (JP); Mitsui, Ryo, Niigata (JP); Kori, Daisuke, Niigata (JP)
(74) Representative: Sonnenhauser, Thomas Martin

(57) **Abstract**

The present invention is a patterning process including the steps of: providing an organic underlayer film, a silicon-containing hard mask, a silicon-containing antireflective film, and a photoresist film in this order on a substrate to be processed; forming a resist pattern in the photoresist film; forming a hard mask middle layer film pattern; forming an organic underlayer film pattern; and forming a pattern in the substrate to be processed, where the silicon-containing antireflective film is formed using a composition for forming a silicon-containing antireflective film containing a crosslinking agent and a polysiloxane containing any one or more of a repeating unit represented by the following general formula (Sx-1), a repeating unit represented by the following general formula (Sx-2), and a partial structure represented by the following general formula (Sx-3). This provides a patterning process according to which it is possible to form a fine pattern without edge roughness.

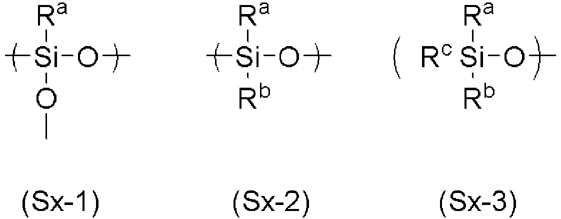

## Description

### TECHNICAL FIELD

The present invention relates to a patterning process using a silicon-containing antireflective film.

### BACKGROUND ART

Along with high integration and high processing speed of LSI, miniaturization of pattern size is rapidly advancing. Along with the miniaturization, lithography technology has achieved a fine patterning by shortening wavelength of a light source and selecting an appropriate resist composition accordingly. The composition mainly used is a positive photoresist composition for monolayer. The monolayer positive photoresist composition not only allows a resist resin to have a skeleton having etching resistance against dry etching with chlorine- or fluorine-based gas plasma, but also provides a switching mechanism that makes an exposed part soluble, thereby dissolving the exposed part to form a pattern and processing a substrate to be processed by dry etching while using the remaining resist pattern as an etching mask.

However, when the pattern becomes finer, that is, the pattern width is reduced without changing the thickness of the photoresist film to be used, resolution performance of the photoresist film is lowered. In addition, pattern development of the photoresist film with a developer excessively increases a so-called aspect ratio of the pattern, resulting in pattern collapse. Therefore, the photoresist film has been thinned along with the miniaturization of the pattern.

On the other hand, a substrate to be processed has been generally processed by dry etching while using a photoresist film having a formed pattern as an etching mask. In practice, however, there is no dry etching method capable of providing an absolute etching selectivity between the photoresist film and the substrate to be processed. The photoresist film is thus also damaged and collapses during processing of the substrate, and the resist pattern cannot be accurately transferred to the substrate to be processed. Accordingly, higher dry etching resistance has been required in a resist composition along with the miniaturization of the pattern. However, on the other hand, a resin used for the photoresist composition needs to have low light absorption at exposure wavelength in order to improve the resolution. For this reason, the resin has shifted to a novolak resin, polyhydroxystyrene, and a resin having an aliphatic polycyclic skeleton as the exposure light shifted from i-line to KrF and ArF, which have shorter wavelength. However, this shift has actually accelerated an etching rate under dry etching conditions for processing the substrate, and recent photoresist compositions having high resolution rather tend to have low etching resistance.

As a result, the substrate to be processed has to be dry etched with a thinner photoresist film having lower etching resistance. Therefore, a demand for finding a composition used in this processing and the process therefor has become urgent.

A multilayer resist method is one of the solutions for the above problems. This method is as follows: a resist middle layer film having a different etching selectivity from that of a photoresist film (i.e., a resist upper layer film) is provided between the resist upper layer film and a substrate to be processed; a pattern (resist pattern) is formed in the resist upper layer film; the resist pattern is trasferred to the resist middle layer film by dry-etching the resist middle layer film while using the resist pattern as a dry etching mask so as to form the pattern (resist middle layer film pattern); and the pattern is further transferred to the substrate to be processed by dry-etching the substrate to be processed while using the resist middle layer film pattern as a dry etching mask.

One of the multilayer resist methods is a three-layer resist method, which can be performed with a typical resist composition used in the monolayer resist method. For example, this three-layer resist method includes the following steps: an organic film containing a novolak resin or the like is formed as a resist underlayer film on a substrate to be processed; a silicon-containing resist middle layer film is formed thereon as a resist middle layer film; and a usual organic photoresist film is formed thereon as a resist upper layer film. Since the organic resist upper layer film ensures an excellent etching selectivity ratio relative to the silicon-containing resist middle layer film when dry etching is performed with fluorine-based gas plasma, the resist upper layer film pattern can be transferred to the silicon-containing resist middle layer film by dry etching with fluorine-based gas plasma. This method allows the resist upper layer film pattern to be transferred to the silicon-containing resist middle layer film (resist middle layer film) even when using a resist composition with which it is difficult to form a pattern having a sufficient film thickness for directly processing the substrate to be processed or a resist composition that has insufficient dry etching resistance for processing the substrate. Then, by subsequently performing transfer of the pattern to the organic film by virtue of dry etching using oxygen gas plasma or hydrogen gas plasma to, the pattern can be transferred to the organic film (resist underlayer film) containing a novolak resin or the like, which has a sufficient dry etching resistance for processing the substrate. As to the resist underlayer film, many materials are already known as disclosed in Patent Document 1, for example.

As silicon-containing resist middle layer films used in such three-layer resist methods, such as the method described above, used are silicon-containing inorganic films obtained by CVD, for example, silicon-containing hard masks, such as SiO₂ films (e.g. Patent Document 2, etc.) and SiON films (e.g. Patent Document 3, etc.), and as film that can be obtained by spin-coating, SOG (spin-on-glass) films (e.g. Patent Document 4, Non Patent Document 1, etc.), crosslinked silsesquioxane films (e.g. Patent Document 5, etc.), etc. Polysilane films (e.g. Patent Document 6, etc.) should also be usable. In advanced three-layer resist methods, SOG films are used in many cases, since an antireflective function can be easily adjusted.

There are some problems with such SOG films, conventionally used in three-layer resist methods. For example, when a resist pattern is to be formed by photolithography, it is well known that exposure light is reflected off a substrate and interferes with incident light, causing a problem in so-called standing waves. Therefore, in order to obtain a fine pattern having no edge roughness of the resist film under the most advanced ArF immersion and high-NA exposure conditions, a middle layer film having an antireflective function is essential. Furthermore, in the most advanced semiconductor processes described above, the thinning of photoresists has progressed considerably, and therefore, middle layer films are also required to be thinned. In next-generation exposure processes, it is required to provide a middle layer film with an antireflective effect with a film thickness of 30 nm or less. In addition, dry etching speed when using oxygen gas plasma, which is commonly used when processing a resist underlayer film, is preferably low, so as to increase the etching selectivity between an SOG film and an underlayer film, and in the course of thinning, SOG films are required to have improved dry etching resistance.

It is difficult to develop an SOG film provided with a high antireflective function and high dry etching resistance in three-layer resist methods. In order to enhance the antireflective function, it is necessary to use a polysiloxane having an organic group having a high refractive index. However, if the introduction rate of organic groups is increased, silicon components in the film are decreased, so that dry etching resistance to oxygen gas is degraded. Meanwhile, there exists a four-layer resist method, in which an antireflective function and a dry etching resistance function are imparted to two different films. Patent Document 7 reports a four-layer resist method using an organic underlayer film, a silicon-containing hard mask, an organic antireflective film, and a photoresist.

An antireflective film needs to function as a layer for preventing interaction between a substrate to be processed and a photoresist, a layer having the function of preventing an adverse effect, on a substrate, of a material used in a photoresist or a substance that is generated during exposure of the photoresist, a layer having the function of preventing the dispersion, to an upper layer photoresist, of a substance that is generated from a substrate during heating and baking, a barrier layer for reducing the poisoning effect of a semiconductor substrate dielectric layer on the photoresist layer, etc. However, such functions of an organic antireflective film are insufficient, and further improvement is thought to be necessary.

Patent Document 8 reports a four-layer resist method using a silicon-containing antireflective film. It is reported that an organic antireflective film is effective for suppressing the poisoning, but this concerns technology adapted to 65-nm pattern rule. It is expected that further improvement is necessary in advanced semiconductor production, which requires technology adapted to pattern rule of 15 nm or less.

For example, in fine processing using ArF excimer laser (wavelength: 193 nm), EUV excimer laser (wavelength: 13 nm), etc., the circuit width is narrow, and therefore, pattern collapse of a photoresist (also simply referred to as a resist) occurs. Meanwhile, to prevent the pattern collapse of resists, the thickness of resist layers has also become thinner as the circuit width decreases. When such a thin film resist is used, the resist underlayer film is also required to have a further improved dry etching rate. However, in an organic resist underlayer film (organic underlayer film), film loss of an organic resist film occurs due to a dry etching gas (e.g. fluorine-based gas, oxygen gas, etc.) for the organic resist underlayer film. On the other hand, when a silicon-containing resist middle layer film is used under an organic resist film, film loss of the organic resist film (the resist film in which the resist pattern is formed) due to the fluorine-based gas is low when the silicon-containing resist middle layer film is dry-etched with a fluorine-based gas while using the resist pattern as an etching mask, and therefore, a resist pattern obtained using a thin film resist can be transferred accurately to the silicon-containing resist middle layer film. Furthermore, by dry-etching the organic underlayer film with an oxygen-based dry etching gas while using the silicon-containing resist middle layer film pattern as an etching mask, the resist pattern can be transferred accurately to the organic underlayer film with little film loss of the silicon-containing resist middle layer film, and by using the organic underlayer film having the transferred resist pattern as an etching mask, the semiconductor substrate can be processed with a fluorine-based gas.

However, the above-described three-layer process of the organic underlayer film on the semiconductor substrate, silicon-containing resist middle layer film, and resist film has a problem that it is technically difficult to achieve both higher refraction and dry etching resistance of a silicon-containing resist middle layer film.

In addition, due to thinning for the purpose of preventing the pattern collapse of resist films, silicon-containing resist middle layer films are also required to be thinned. Accordingly, under the state-of-the-art ArF immersion and high-NA exposure conditions, silicon-containing resist middle layer films is required to have higher refraction for further improving the antireflective effect. To form a silicon-containing resist middle layer film having high refraction, SOG materials containing a polysiloxane having an organic group having a high refractive index is generally used, but these materials have a high introduction rate of organic groups and silicon components in the film decrease, and therefore, dry etching resistance to oxygen gas is insufficient. To transfer a fine pattern having no edge roughness to a substrate to be processed with high precision, a silicon-containing resist middle layer film excellent in dry etching resistance is necessary.

Incidentally, Patent Document 9 discloses some patterning processes. Patent Document 9 discloses, as an example, forming an organic film on a body to be processed, forming a silicon-containing resist underlayer film on the organic film, and forming a resist upper layer film on the silicon-containing resist underlayer film. As another example, Patent Document 9 discloses forming a hard mask mainly containing carbon on a body to be processed, forming a silicon-containing resist underlayer film on the hard mask, and forming a resist upper layer film on the silicon-containing resist underlayer film. However, in these processes, the antireflective effect under advanced ArF immersion and high-NA exposure conditions is insufficient, and it is thought that a new method that can form a fine pattern having no edge roughness is needed.

### CITATION LIST

### PATENT LITERATURE

Patent Document 1: JP2004-205685A
Patent Document 2: JPH7-183194A
Patent Document 3: JPH7-181688A
Patent Document 4: JPH5-291208A
Patent Document 5: JP2005-520354A
Patent Document 6: JPH11-60735A
Patent Document 7: JP5057107B2
Patent Document 8: JP4481902B2
Patent Document 9: JP2022-90309

### NON PATENT LITERATURE

Non Patent Document 1: J. Appl. Polym. Sci., Vol. 88, 636-640 (2003)

### SUMMARY OF INVENTION

### TECHNICAL PROBLEM

The present invention has been made to solve the above-described problems, and an object thereof is to provide a patterning process according to which it is possible to form a fine pattern without edge roughness.

### SOLUTION TO PROBLEM

To achieve the object, the present invention provides a patterning process comprising the steps of:
(1) providing (A) an organic underlayer film, (B) a silicon-containing hard mask, (C) a silicon-containing antireflective film, and (D) a photoresist film in this order on a substrate to be processed;
(2) subjecting a pattern circuit region of the photoresist film (D) to exposure to form an exposed pattern and then developing the exposed pattern with a developer to form a resist pattern in the photoresist film (D);
(3) forming a hard mask middle layer film pattern by etching the silicon-containing antireflective film (C) and the silicon-containing hard mask (B) while using the obtained resist pattern as an etching mask;
(4) forming an organic underlayer film pattern by etching the organic underlayer film (A) while using the obtained hard mask middle layer film pattern as an etching mask; and
(5) forming a pattern in the substrate to be processed by etching the substrate to be processed while using the obtained organic underlayer film pattern as an etching mask,
wherein the silicon-containing antireflective film (C) is formed using a composition for forming a silicon-containing antireflective film containing a crosslinking agent and a polysiloxane containing any one or more of a repeating unit represented by the following general formula (Sx-1), a repeating unit represented by the following general formula (Sx-2), and a partial structure represented by the following general formula (Sx-3), 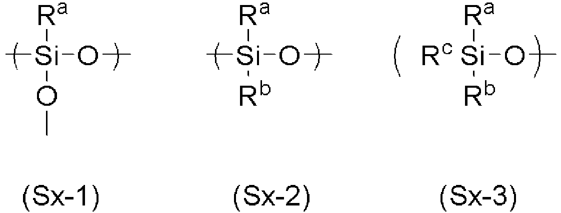 wherein R^{a}, R^{b}, and R^{c} are each identical to or different from each other and represent a monovalent organic group having 1 to 30 carbon atoms.

According to such a patterning process, a high antireflective effect can be exhibited under ArF immersion and high-NA exposure conditions by virtue of the combination of the silicon-containing hard mask (B) and the silicon-containing antireflective film (C), and therefore, a fine pattern with no edge roughness can be obtained. Furthermore, by using the composition for forming a silicon-containing antireflective film containing a crosslinking agent, a better poisoning-suppression effect than that of conventional antireflective films can be exhibited, and since adhesiveness to a resist pattern is excellent, an effect of preventing fine pattern collapse can also be exhibited. Therefore, according to the inventive patterning process, it is possible to transfer a resist pattern shape onto a substrate to be processed with high precision.

Furthermore, as the silicon-containing hard mask (B), a layer selected from the group consisting of a silicon oxide film, a silicon nitride film, and a silicon oxynitride film is preferably formed.

By using such a silicon-containing hard mask (B), a resist pattern shape can be transferred more accurately onto a substrate to be processed. Furthermore, an excellent antireflective function can be imparted by the combination with the silicon-containing antireflective film (C).

The silicon-containing antireflective film (C) is preferably formed using the polysiloxane, at least one of the R^{a} to R^{c} in the general formulae (Sx-1) to (Sx-3) being an organic group having one or more carbon-oxygen single bonds or carbon-oxygen double bonds.

By using such a silicon-containing antireflective film (C), the adhesiveness to the resist pattern can be further enhanced, and fine pattern collapse can be prevented more certainly.

The silicon-containing antireflective film (C) is preferably formed using, as the crosslinking agent, a compound containing an isocyanuric acid structure.

By using such a silicon-containing antireflective film (C), the density of the silicon-containing antireflective film is improved, and thus, it is possible to improve further the ability to suppress poisoning, where a basic component that may be generated from the silicon-containing hard mask (C) moves to the photoresist film (D) and degrades the sensitivity or resolution of the resist. Furthermore, the adhesiveness to the resist pattern can be further improved, and fine pattern collapse can be prevented more certainly. Moreover, it is possible to enhance the refractive index of the silicon-containing antireflective film (C), and an even better antireflective function can be imparted.

The organic underlayer film (A) is preferably formed by a CVD method.

By forming the organic underlayer film (A) in this manner, a resist pattern shape can be transferred to the substrate to be processed with higher precision than in the case of a patterning process using a coating-type organic underlayer film.

As the organic underlayer film (A), a film including any of a graphene film, an amorphous carbon film, and a diamond-like carbon film is preferably formed.

By using such an organic underlayer film (A), high resistance to fluorine-based gas, used when processing the substrate to be processed by dry etching, is exhibited, and therefore, a resist pattern shape can be transferred to the substrate to be processed with higher precision.

The silicon-containing hard mask (B) and the silicon-containing antireflective film (C) are preferably formed in such a manner that a film thickness FTb of the silicon-containing hard mask (B) and a film thickness FTc of the silicon-containing antireflective film (C) satisfy a relationship FTb > FTc.

By using a silicon-containing antireflective film (C) having a film thickness within such a range, it is possible to transfer a resist pattern shape to the silicon-containing antireflective film (C) at high speed, and therefore, a pattern shape having less roughness can be transferred to the substrate to be processed.

The silicon-containing antireflective film (C) is preferably formed in such a manner that the silicon-containing antireflective film (C) has a film thickness of 15 nm or less.

By using a silicon-containing antireflective film (C) having a film thickness within such a range, it is possible to transfer a resist pattern shape to the silicon-containing antireflective film (C) at high speed, and therefore, a pattern shape having less roughness can be transferred to the substrate to be processed.

### ADVANTAGEOUS EFFECTS OF INVENTION

As described above, according to the inventive patterning process, it is possible to obtain a fine pattern without edge roughness while suppressing poisoning.

### BRIEF DESCRIPTION OF DRAWINGS

FIG. 1 is an explanatory diagram of an example (four-layer resist process) of the inventive patterning process.
FIG. 2 is an explanatory diagram of an example (three-layer resist process) of a patterning process for a Comparative Example.
FIG. 3 is an explanatory diagram of reflectance calculation in a patterning process.

### DESCRIPTION OF EMBODIMENTS

As stated above, there have been demands for the development of a patterning process according to a multilayer resist method having an excellent antireflective function that makes it possible to form a fine pattern without edge roughness and having processing selectivity that makes it possible to transfer a resist pattern shape to a substrate to be processed with high precision in a fine patterning process using ArF immersion and high-NA exposure conditions in a semiconductor device manufacturing process.

In addition, as explained earlier, a three-layer process with an organic underlayer film, a silicon-containing hard mask, and a resist film on a semiconductor substrate has a problem that it is technically difficult to achieve both higher refraction and dry etching resistance of a silicon-containing hard mask.

To counter such problems, the present inventors have considered whether the problems can be solved by providing a silicon-containing antireflective film between a silicon-containing hard mask (B) and a photoresist film (D). Meanwhile, a silicon-containing antireflective film in Patent Document 8 has a problem of suppressing poisoning into a photoresist film from a resist underlayer, and earnestly studied silicon-containing antireflective films. As a result, the present inventors have found out that a silicon-containing antireflective film (C) formed using a composition containing a crosslinking agent and a polysiloxane containing any one or more of repeating units and structure represented by the formulae (Sx-1) to (Sx-3) has both an excellent poisoning-suppression effect and an excellent antireflective effect, and therefore, makes it possible to transfer a fine pattern having no edge roughness while sufficiently suppressing poisoning.

The present inventors have then found out that the above-described object can be achieved by a patterning process including the steps of: providing each layer of (A) an organic underlayer film, (B) a silicon-containing hard mask, (C) the silicon-containing antireflective film, and (D) a photoresist film in this order on a semiconductor substrate; exposing and developing the photoresist film (D) to form a resist pattern; and processing each layer on the basis of the resist pattern to transfer the resist pattern to the substrate to be processed in the end. Thus, the present invention has been completed.

That is, the present invention is a patterning process comprising the steps of:
(1) providing (A) an organic underlayer film, (B) a silicon-containing hard mask, (C) a silicon-containing antireflective film, and (D) a photoresist film in this order on a substrate to be processed;
(2) subjecting a pattern circuit region of the photoresist film (D) to exposure to form an exposed pattern and then developing the exposed pattern with a developer to form a resist pattern in the photoresist film (D);
(3) forming a hard mask middle layer film pattern by etching the silicon-containing antireflective film (C) and the silicon-containing hard mask (B) while using the obtained resist pattern as an etching mask;
(4) forming an organic underlayer film pattern by etching the organic underlayer film (A) while using the obtained hard mask middle layer film pattern as an etching mask; and
(5) forming a pattern in the substrate to be processed by etching the substrate to be processed while using the obtained organic underlayer film pattern as an etching mask,
wherein the silicon-containing antireflective film (C) is formed using a composition for forming a silicon-containing antireflective film containing a crosslinking agent and a polysiloxane containing any one or more of a repeating unit represented by the following general formula (Sx-1), a repeating unit represented by the following general formula (Sx-2), and a partial structure represented by the following general formula (Sx-3), 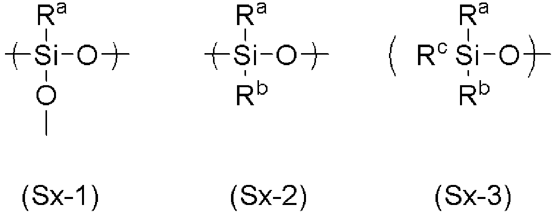 wherein R^{a}, R^{b}, and R^{c} are each identical to or different from each other and represent a monovalent organic group having 1 to 30 carbon atoms.

Hereinafter, the present invention will be described in detail, but the present invention is not limited thereto.

### <Patterning Process>

The present invention is a patterning process including the steps of:
(1) providing (A) an organic underlayer film, (B) a silicon-containing hard mask, (C) a silicon-containing antireflective film, and (D) a photoresist film in this order on a substrate to be processed;
(2) subjecting a pattern circuit region of the photoresist film (D) to exposure to form an exposed pattern and then developing the exposed pattern with a developer to form a resist pattern in the photoresist film (D);
(3) forming a hard mask middle layer film pattern by etching the silicon-containing antireflective film (C) and the silicon-containing hard mask (B) while using the obtained resist pattern as an etching mask;
(4) forming an organic underlayer film pattern by etching the organic underlayer film (A) while using the obtained hard mask middle layer film pattern as an etching mask; and
(5) forming a pattern in the substrate to be processed by etching the substrate to be processed while using the obtained organic underlayer film pattern as an etching mask,
where the silicon-containing antireflective film (C) is formed using a composition for forming a silicon-containing antireflective film containing a crosslinking agent and a polysiloxane containing any one or more of a repeating unit represented by the following general formula (Sx-1), a repeating unit represented by the following general formula (Sx-2), and a partial structure represented by the following general formula (Sx-3).

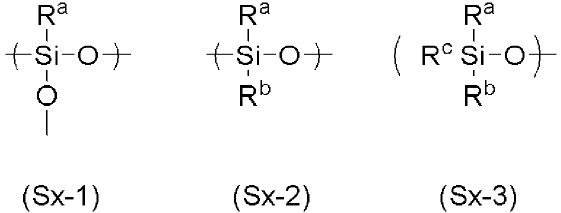

In the formulae, R^{a}, R^{b}, and R^{c} are each identical to or different from each other and represent a monovalent organic group having 1 to 30 carbon atoms.

According to the above-described patterning process, the combination of the silicon-containing antireflective film (C), having an excellent antireflective function, and the silicon-containing hard mask (B), having excellent dry etching resistance, makes it possible to transfer a resist pattern shape having no edge roughness to a substrate to be processed with high accuracy while sufficiently suppressing poisoning even in a fine patterning process under ArF immersion and high-NA exposure conditions in a semiconductor device manufacturing process.

In the following, each step of the inventive patterning process will be described in more detail.

### [(1) Step of Providing (Laminating)]

This step (1) is a step of providing (laminating) (A) an organic underlayer film (layer A), (B) a silicon-containing hard mask (layer B), (C) a silicon-containing antireflective film (layer C), and (D) a photoresist film (layer D) on a substrate to be processed in this order. In the inventive patterning process, at least the above-described four layers are formed.

### <(A) Organic Underlayer Film (Layer A)>

Examples of organic underlayer film materials usable for the organic underlayer film (A) (layer A) include materials already known as underlayer films for three-layer resist methods or two-layer resist methods using a silicon resist composition. Examples include resins and compositions shown in JP2012-1687A, JP2012-77295A, JP2004-264710A, JP2005-043471A, JP2005-250434A, JP2007-293294A, JP2008-65303A, JP2004-205685A, JP2007-171895A, JP2009-14816A, JP2007-199653A, JP2008-274250A, JP2010-122656A, JP2012-214720A, JP2014-29435A, WO2012/077640A1, WO2010/147155A1, WO2012/176767A1, JP2005-128509A, JP2006-259249A, JP2006-259482A, JP2006-293298A, JP2007-316282A, JP2012-145897A, JP2017-119671A, JP2019-44022A, etc.

The organic underlayer film (A) can be, for example, formed on a substrate to be processed by a spin-coating method or the like, using a composition solution containing the above-described organic underlayer film material. After forming the organic underlayer film by a spin-coating method etc., it is desirable to perform baking for evaporating the organic solvent. The baking temperature is preferably in the range of 100 to 600°C, and the baking time is preferably in the range of 10 to 300 seconds.

It is also possible to adopt, as an organic underlayer film, an organic hard mask formed by a CVD method or an ALD method instead of a coating method using the spin-coating method or the like. In the inventive patterning process, the organic underlayer film is preferably formed by a CVD method.

By using an organic hard mask formed by a CVD method as the organic underlayer film, it is possible to transfer the resist pattern shape to the substrate to be processed with higher precision. An organic hard mask formed by a CVD method exhibits higher resistance to dry etching using a fluorine-based gas than that of an organic underlayer film formed from a coating-type organic underlayer film material, and therefore, is more useful for fine pattern formation.

As the organic underlayer film, it is preferable to form a film including any of a graphene film, an amorphous carbon film, and a diamond-like carbon film. Such a film can be formed by a CVD method, for example.

According to the patterning process using the above-described organic underlayer film, the organic underlayer film exhibits higher resistance to a fluorine-based gas used when processing the substrate to be processed by dry etching than an organic underlayer film formed using a coating-type organic underlayer film material, and therefore, it is possible to transfer the resist pattern shape to the substrate to be processed with higher precision.

The organic underlayer film preferably has a thickness of 10 to 1,000 nm, more preferably 15 nm to 100 nm, and further preferably 20 nm to 50 nm.

### <(B) Silicon-Containing Hard Mask (Layer B)>

Examples of silicon-containing hard mask materials usable for forming the silicon-containing hard mask (B) (layer B) in the inventive patterning process include polysiloxane-based resist middle layer film materials. Examples include materials disclosed in JP471603B etc.

In conventional silicon-containing hard mask materials, preferably used is a polysiloxane, which has a pendant phenyl group or a pendant light-absorbing group having a silicon-silicon bond for imparting an antireflective effect, and which is to be crosslinked by an acid or heat. On the other hand, in the inventive patterning process, reflection can be suppressed by imparting an antireflective function to the silicon-containing antireflective film, and therefore, it is possible to design the silicon-containing hard mask material so as to minimize the amount of organic groups, which may degrade the dry etching resistance when dry-etching the organic underlayer film with an oxygen-based gas and degrade the pattern shape. Thus, high-precision processing of the substrate to be processed can be realized.

The silicon-containing hard mask can be, for example, formed on a substrate to be processed by a spin-coating method or the like, using a composition solution containing the above-described silicon-containing hard mask material. After forming the silicon-containing hard mask by a spin-coating method etc., it is desirable to perform baking for evaporating the organic solvent. The baking temperature is preferably in the range of 100 to 600°C, and the baking time is preferably in the range of 10 to 300 seconds.

Alternatively, it is also possible to form the silicon-containing hard mask (B) (inorganic hard mask) by a CVD method or an ALD method instead of the spin-coating method or the like. Specifically, it is preferable to form, as the silicon-containing hard mask (B), a layer selected from the group consisting of a silicon oxide film, a silicon nitride film, and a silicon oxynitride film. For example, examples of methods for forming a silicon nitride film are disclosed in JP2002-334869A and WO2004/066377A1.

In the inventive patterning process, it is preferable to adopt, as the silicon-containing hard mask (B), an inorganic hard mask (a layer selected from a silicon oxide film, a silicon nitride film, and a silicon oxynitride film) formed by a CVD method.

In a patterning process in which the inorganic hard mask is formed as the silicon-containing hard mask (B) by a CVD method, the inorganic hard mask exhibits high resistance to the oxygen-based gas used when processing the organic underlayer film by dry etching, and therefore, it is possible to transfer the resist pattern shape to the substrate to be processed with high precision. Furthermore, when the inorganic hard mask is used, the inventive patterning process exerts excellent effects from the viewpoint of suppressing poisoning into the photoresist layer by the organic underlayer film and the underlying substrate to be processed, and therefore, is useful in forming a fine pattern.

The silicon-containing hard mask (B) preferably has a film thickness FTb in the range of 5 to 200 nm, more preferably 10 to 100 nm.

Furthermore, as the silicon-containing hard mask (B), a silicon oxynitride film (SiON), highly effective as an antireflective film, is the most favorably used. The substrate temperature when the SiON film is formed is 300 to 500°C, and therefore, the organic underlayer film needs to be able to withstand a temperature of 300 to 500°C.

### <(C) Silicon-Containing Antireflective Film (Layer C)>

In the inventive patterning process, the silicon-containing antireflective film (C) (layer C) is formed using a composition for forming a silicon-containing antireflective film, containing the polysiloxane (Sx) and crosslinking agent, which are described in detail below.

### (Polysiloxane (Sx))

The polysiloxane (Sx) contains any one or more of a repeating unit represented by the following general formula (Sx-1), a repeating unit represented by the following general formula (Sx-2), and a partial structure represented by the following general formula (Sx-3). Such a polysiloxane (Sx) can also be referred to as a thermally-crosslinking polysiloxane. 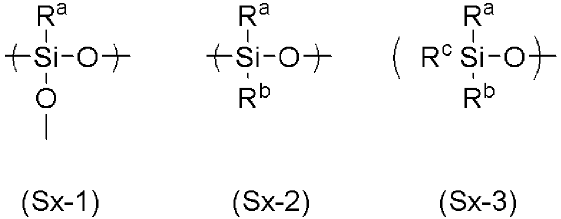 In the formulae, R^{a}, R^{b}, and R^{c} are each identical to or different from each other and represent a monovalent organic group having 1 to 30 carbon atoms.

The polysiloxane (Sx) may be manufactured, for example, by the hydrolysis condensation of a hydrolysable monomer (Sm) described below.

Specific examples of the hydrolysable monomer (Sm) include tetramethoxysilane, tetraethoxysilane, tetrapropoxysilane, tetraisopropoxysilane, trimethoxysilane, triethoxysilane, tripropoxysilane, triisopropoxysilane, methyltrimethoxysilane, methyltriethoxysilane, methyltripropoxysilane, methyltriisopropoxysilane, ethyltrimethoxysilane, ethyltriethoxysilane, ethyltripropoxysilane, ethyltriisopropoxysilane, vinyltrimethoxysilane, vinyltriethoxysilane, vinyltripropoxysilane, vinyltriisopropoxysilane, propyltrimethoxysilane, propyltriethoxysilane, propyltripropoxysilane, propyltriisopropoxysilane, isopropyltrimethoxysilane, isopropyltriethoxysilane, isopropyltripropoxysilane, isopropyltriisopropoxysilane, butyltrimethoxysilane, butyltriethoxysilane, butyltripropoxysilane, butyltriisopropoxysilane, sec-butyltrimethoxysilane, sec-butyltriethoxysilane, sec-butyltripropoxysilane, sec-butyltriisopropoxysilane, t-butyltrimethoxysilane, t-butyltriethoxysilane, t-butyltripropoxysilane, t-butyltriisopropoxysilane, cyclopropyltrimethoxysilane, cyclopropyltriethoxysilane, cyclopropyltripropoxysilane, cyclopropyltriisopropoxysilane, cyclobutyltrimethoxysilane, cyclobutyltriethoxysilane, cyclobutyltripropoxysilane, cyclobutyltriisopropoxysilane, cyclopentyltrimethoxysilane, cyclopentyltriethoxysilane, cyclopentyltripropoxysilane, cyclopentyltriisopropoxysilane, cyclohexyltrimethoxysilane, cyclohexyltriethoxysilane, cyclohexyltripropoxysilane, cyclohexyltriisopropoxysilane, cyclohexenyltrimethoxysilane, cyclohexenyltriethoxysilane, cyclohexenyltripropoxysilane, cyclohexenyltriisopropoxysilane, cyclohexenylethyltrimethoxysilane, cyclohexenylethyltriethoxysilane, cyclohexenylethyltripropoxysilane, cyclohexenylethyltriisopropoxysilane, cyclooctyltrimethoxysilane, cyclooctyltriethoxysilane, cyclooctyltripropoxysilane, cyclooctyltriisopropoxysilane, cyclopentadienylpropyltrimethoxysilane, cyclopentadienylpropyltriethoxysilane, cyclopentadienylpropyltripropoxysilane, cyclopentadienylpropyltriisopropoxysilane, bicycloheptenyltrimethoxysilane, bicycloheptenyltriethoxysilane, bicycloheptenyltripropoxysilane, bicycloheptenyltriisopropoxysilane, bicycloheptyltrimethoxysilane, bicycloheptyltriethoxysilane, bicycloheptyltripropoxysilane, bicycloheptyltriisopropoxysilane, adamantyltrimethoxysilane, adamantyltriethoxysilane, adamantyltripropoxysilane, adamantyltriisopropoxysilane, phenyltrimethoxysilane, phenyltriethoxysilane, phenyltripropoxysilane, phenyltriisopropoxysilane, benzyltrimethoxysilane, benzyltriethoxysilane, benzyltripropoxysilane, benzyltriisopropoxysilane, anisyltrimethoxysilane, anisyltriethoxysilane, anisyltripropoxysilane, anisyltriisopropoxysilane, tolyltrimethoxysilane, tolyltriethoxysilane, tolyltripropoxysilane, tolyltriisopropoxysilane, phenethyltrimethoxysilane, phenethyltriethoxysilane, phenethyltripropoxysilane, phenethyltriisopropoxysilane, naphthyltrimethoxysilane, naphthyltriethoxysilane, naphthyltripropoxysilane, naphthyltriisopropoxysilane, dimethyldimethoxysilane, dimethyldiethoxysilane, methylethyldimethoxysilane, methylethyldiethoxysilane, dimethyldipropoxysilane, dimethyldiisopropoxysilane, diethyldimethoxysilane, diethyldiethoxysilane, diethyldipropoxysilane, diethyldiisopropoxysilane, dipropyldimethoxysilane, dipropyldiethoxysilane, dipropyldipropoxysilane, dipropyldiisopropoxysilane, diisopropyldimethoxysilane, diisopropyldiethoxysilane, diisopropyldipropoxysilane, diisopropyldiisopropoxysilane, dibutyldimethoxysilane, dibutyldiethoxysilane, dibutyldipropoxysilane, dibutyldiisopropoxysilane, di-sec-butyldimethoxysilane, di-sec-butyldiethoxysilane, di-sec-butyldipropoxysilane, di-sec-butyldiisopropoxysilane, di-t-butyldimethoxysilane, di-t-butyldiethoxysilane, di-t-butyldipropoxysilane, di-t-butyldiisopropoxysilane, dicyclopropyldimethoxysilane, dicyclopropyldiethoxysilane, dicyclopropyldipropoxysilane, dicyclopropyldiisopropoxysilane, dicyclobutyldimethoxysilane, dicyclobutyldiethoxysilane, dicyclobutyldipropoxysilane, dicyclobutyldiisopropoxysilane, dicyclopentyldimethoxysilane, dicyclopentyldiethoxysilane, dicyclopentyldipropoxysilane, dicyclopentyldiisopropoxysilane, dicyclohexyldimethoxysilane, dicyclohexyldiethoxysilane, dicyclohexyldipropoxysilane, dicyclohexyldiisopropoxysilane, dicyclohexenyldimethoxysilane, dicyclohexenyldiethoxysilane, dicyclohexenyldipropoxysilane, dicyclohexenyldiisopropoxysilane, dicyclohexenylethyldimethoxysilane, dicyclohexenylethyldiethoxysilane, dicyclohexenylethyldipropoxysilane, dicyclohexenylethyldiisopropoxysilane, dicyclooctyldimethoxysilane, dicyclooctyldiethoxysilane, dicyclooctyldipropoxysilane, dicyclooctyldiisopropoxysilane, dicyclopentadienylpropyldimethoxysilane, dicyclopentadienylpropyldiethoxysilane, dicyclopentadienylpropyldipropoxysilane, dicyclopentadienylpropyldiisopropoxysilane, bis(bicycloheptenyl)dimethoxysilane, bis(bicycloheptenyl)diethoxysilane, bis(bicycloheptenyl)dipropoxysilane, bis(bicycloheptenyl)diisopropoxysilane, bis(bicycloheptyl)dimethoxysilane, bis(bicycloheptyl)diethoxysilane, bis(bicycloheptyl)dipropoxysilane, bis(bicycloheptyl)diisopropoxysilane, diadamantyldimethoxysilane, diadamantyldiethoxysilane, diadamantyldipropoxysilane, diadamantyldiisopropoxysilane, diphenyldimethoxysilane, diphenyldiethoxysilane, methylphenyldimethoxysilane, methylphenyldiethoxysilane, diphenyldipropoxysilane, diphenyldiisopropoxysilane, trimethylmethoxysilane, trimethylethoxysilane, dimethylethylmethoxysilane, dimethylethylethoxysilane, dimethylphenylmethoxysilane, dimethylphenylethoxysilane, dimethylbenzylmethoxysilane, dimethylbenzylethoxysilane, dimethylphenethylmethoxysilane, dimethylphenethylethoxysilane, and the like.

Preferable examples of the hydrolysable monomer (Sm) include tetramethoxysilane, tetraethoxysilane, methyltrimethoxysilane, methyltriethoxysilane, ethyltrimethoxysilane, ethyltriethoxysilane, vinyltrimethoxysilane, vinyltriethoxysilane, propyltrimethoxysilane, propyltriethoxysilane, isopropyltrimethoxysilane, isopropyltriethoxysilane, butyltrimethoxysilane, butyltriethoxysilane, isobutyltrimethoxysilane, isobutyltriethoxysilane, allyltrimethoxysilane, allyltriethoxysilane, cyclopentyltrimethoxysilane, cyclopentyltriethoxysilane, cyclohexyltrimethoxysilane, cyclohexyltriethoxysilane, cyclohexenyltrimethoxysilane, cyclohexenyltriethoxysilane, phenyltrimethoxysilane, phenyltriethoxysilane, benzyltrimethoxysilane, benzyltriethoxysilane, phenethyltrimethoxysilane, phenethyltriethoxysilane, dimethyldimethoxysilane, dimethyldiethoxysilane, diethyldimethoxysilane, diethyldiethoxysilane, methylethyldimethoxysilane, methylethyldiethoxysilane, dipropyldimethoxysilane, dibutyldimethoxysilane, methylphenyldimethoxysilane, methylphenyldiethoxysilane, trimethylmethoxysilane, dimethylethylmethoxysilane, dimethylphenylmethoxysilane, dimethylbenzylmethoxysilane, dimethylphenethylmethoxysilane, and the like.

Other examples of the organic groups represented by R^{a}, R^{b}, and R^{c}, corresponding to the compounds given above as examples of the hydrolysable monomer (Sm) include organic groups having one or more carbon-oxygen single bonds or carbon-oxygen double bonds. Specific examples include organic groups having one or more groups selected from the group consisting of an ether bond, an ester bond, alkoxy groups, a hydroxy group, etc. Examples of the organic groups include ones shown by the following general formula (Sm-R).

(P-Q₁-(S₁)ᵥ₁-Q₂-)ᵤ-(T)ᵥ₂-Q₃-(S₂)ᵥ₃-Q₄- (Sm-R)

In the general formula (Sm-R), P represents a hydrogen atom, a cyclic ether group, a hydroxy group, an alkoxy group having 1 to 4 carbon atoms, an alkylcarbonyloxy group having 1 to 6 carbon atoms, or an alkylcarbonyl group having 1 to 6 carbon atoms; Q₁, Q₂, Q₃, and Q₄ each independently represent -C_{q}H_{(2q-p)}Pₚ-, where P is as defined above, "p" represents an integer of 0 to 3, and "q" represents an integer of 0 to 10, provided that q=0 means a single bond; "u" represents an integer of 0 to 3; S₁ and S₂ each independently represent -O-, -CO-, -OCO-, -COO-, or -OCOO-. v1, v2, and v3 each independently represent 0 or 1. T represents a divalent atom other than carbon, or a divalent group selected from the group consisting of an alicyclic, aromatic, or heterocyclic ring. As T, examples of the alicyclic, aromatic, or heterocyclic ring optionally containing a hetero atom such as an oxygen atom are shown below. In T, positions bonded to Q₂ and Q₃ are not particularly limited, and can be selected appropriately in consideration of reactivity dependent on steric factors, availability of commercial reagents used in the reaction, and so on.

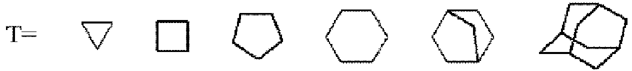

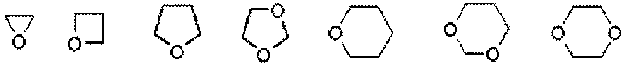

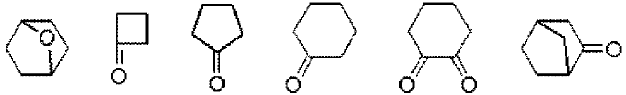

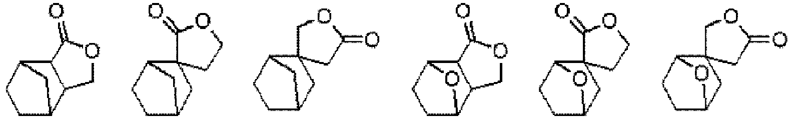

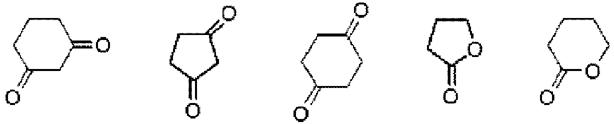

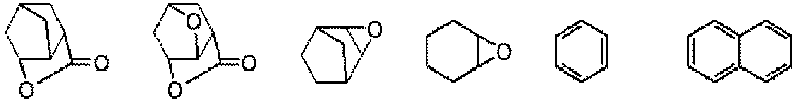

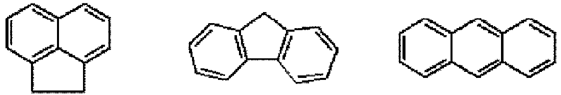

Preferable examples of the organic groups having one or more carbon-oxygen single bonds or carbon-oxygen double bonds in the general formula (Sm-R) include the following. Note that, in the following formulae, (Si) is depicted to show a bonding site to Si.

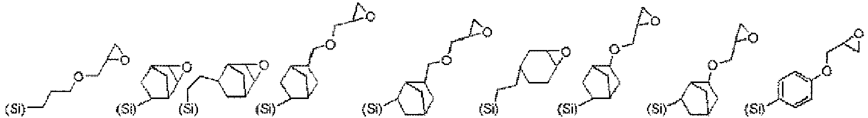

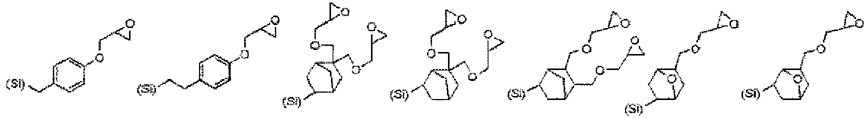

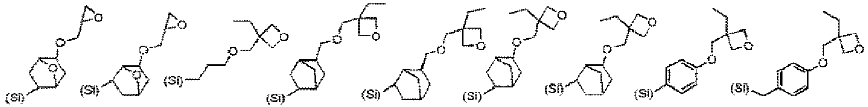

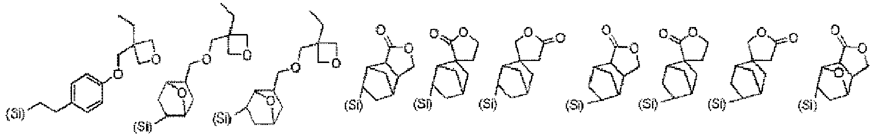

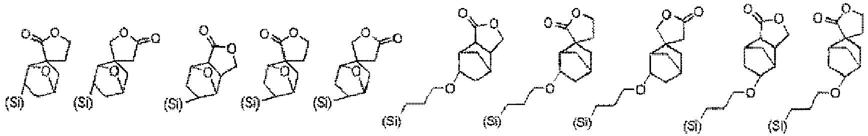

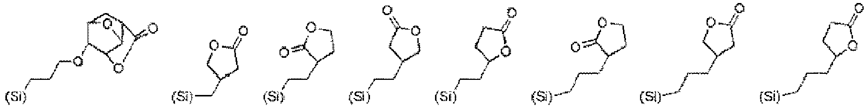

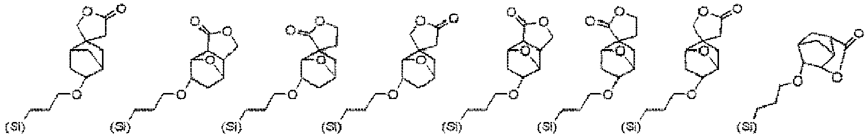

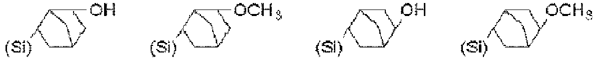

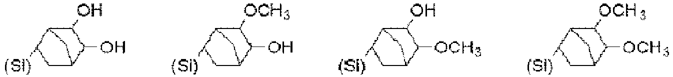

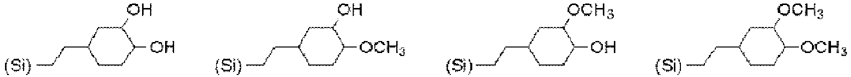

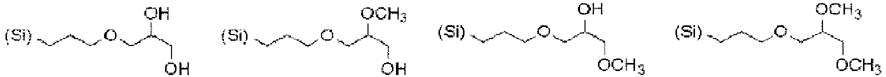

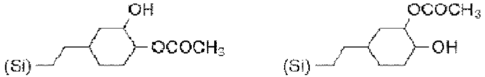

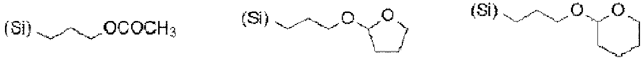

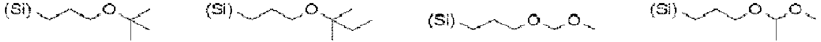

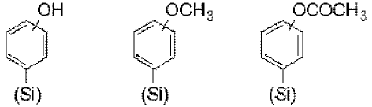

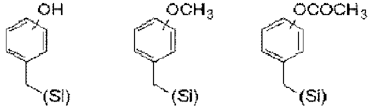

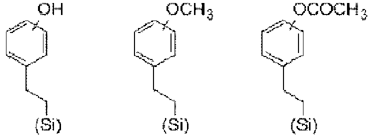

Furthermore, as examples of the organic groups of R^{a}, R^{b}, and R^{c}, an organic group containing a silicon-silicon bond can also be used. Specific examples thereof include the following.

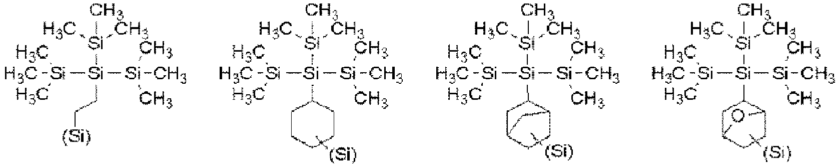

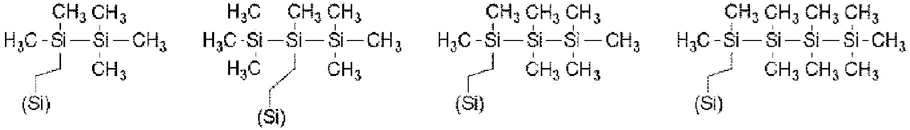

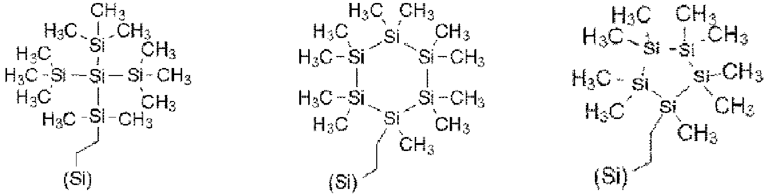

Further, as examples of the organic groups of R^{a}, R^{b}, and R^{c}, organic groups having a protective group that is decomposed with an acid can also be used. Specific examples thereof include organic groups shown in paragraphs [0043] to [0048] of JP2013-167669A and organic groups obtained from silicon compounds shown in paragraph [0056] of JP2013-224279A.

Furthermore, as examples of the organic groups of R^{a}, R^{b}, and R^{c}, an organic group having a fluorine atom can also be used. Specific examples thereof include organic groups obtained from silicon compounds shown in paragraphs [0059] to [0065] of JP2012-53253A.

To the hydrolysable monomer (Sm), 1, 2, or 3 chlorine atoms, bromine atoms, iodine atoms, acetoxy groups, methoxy groups, ethoxy groups, propoxy groups, butoxy groups, or the like are bonded as hydrolysable groups on the silicon atom shown as (Si) in the partial structures shown above.

### [Method for Synthesizing Polysiloxane (Sx)]

### (Synthesis Method 1: Acid Catalyst)

The polysiloxane (Sx) used in the inventive patterning process can be produced by, for example, the hydrolysis condensation of one kind of the hydrolysable monomer (Sm) or a mixture of two or more kinds thereof in the presence of an acid catalyst.

Examples of the acid catalyst used in this event include organic acids, such as formic acid, acetic acid, oxalic acid, maleic acid, methanesulfonic acid, benzenesulfonic acid, and toluenesulfonic acid; and inorganic acids such as hydrofluoric acid, hydrochloric acid, hydrobromic acid, sulfuric acid, nitric acid, perchloric acid, and phosphoric acid. The catalyst can be used in an amount of 1×10⁻⁶ to 10 mol, preferably 1×10⁻⁵ to 5 mol, more preferably 1×10⁻⁴ to 1 mol, relative to 1 mol of the monomer.

When the polysiloxane (Sx) is obtained from these monomers by the hydrolysis condensation, water can be added in an amount of, for example, 0.01 to 100 mol, more preferably 0.05 to 50 mol, further preferably 0.1 to 30 mol, per mol of the hydrolysable substituent bonded to the monomer. When the amount is 100 mol or less, a reaction device can be made small and economical.

As the operation method, for example, the monomer can be added to an aqueous solution of a catalyst to initiate the hydrolysis condensation reaction. In this event, an organic solvent may be added to the aqueous solution of the catalyst, or the monomer may be diluted with an organic solvent, or both of these operations may be performed. The reaction temperature can be, for example, 0 to 100°C, preferably 5 to 80°C. As a preferable method, when the monomer is added dropwise, the temperature is maintained at 5 to 80°C, and then the mixture is aged at 20 to 80°C.

The organic solvent which can be added to the aqueous solution of the catalyst or with which the monomer can be diluted is preferably methanol, ethanol, 1-propanol, 2-propanol, 1-butanol, 2-butanol, 2-methyl-1-propanol, acetone, acetonitrile, tetrahydrofuran, toluene, hexane, ethyl acetate, methyl ethyl ketone, methyl isobutyl ketone, cyclohexanone, methyl amyl ketone, butanediol monomethyl ether, propylene glycol monomethyl ether, ethylene glycol monomethyl ether, butanediol monoethyl ether, propylene glycol monoethyl ether, ethylene glycol monoethyl ether, propylene glycol dimethyl ether, diethylene glycol dimethyl ether, propylene glycol monomethyl ether acetate, propylene glycol monoethyl ether acetate, ethyl pyruvate, butyl acetate, methyl 3-methoxypropionate, ethyl 3-ethoxypropionate, tert-butyl acetate, t-butyl propionate, propylene glycol mono-t-butyl ether acetate, γ-butyrolactone, mixtures thereof, and the like.

Among these solvents, water-soluble solvents are preferable. Examples thereof include alcohols, such as methanol, ethanol, 1-propanol, and 2-propanol; polyhydric alcohols, such as ethylene glycol and propylene glycol; polyhydric alcohol condensate derivatives, such as butanediol monomethyl ether, propylene glycol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, and ethylene glycol monopropyl ether; acetone, acetonitrile, tetrahydrofuran, and the like. Among these, particularly preferable is one having a boiling point of 100°C or lower.

Note that the organic solvent can be used in an amount of 0 to 1,000 ml, particularly preferably 0 to 500 ml, relative to 1 mol of the monomer, for example. When the organic solvent is used in a small amount, only a small reaction vessel is required, and this is economical.

Then, if necessary, neutralization reaction of the catalyst is carried out to obtain an aqueous solution of a reaction mixture. In this event, the amount of an alkaline substance usable for the neutralization is preferably 0.1 to 2 equivalents relative to the acid used as the catalyst. This alkaline substance may be any substance as long as it shows alkalinity in water.

Subsequently, by-products such as alcohol produced by the hydrolysis condensation reaction are preferably removed from the reaction mixture by a procedure such as removal under reduced pressure. In this event, the reaction mixture is heated at a temperature of preferably 0 to 100°C, more preferably 10 to 90°C, further preferably 15 to 80°C, although the temperature depends on the kinds of the added organic solvent, the alcohol produced in the reaction, and so forth. Additionally, in this event, the degree of vacuum is preferably atmospheric pressure or less, more preferably 80 kPa or less in absolute pressure, further preferably 50 kPa or less in absolute pressure, although the degree of vacuum varies depending on the kinds of the organic solvent, alcohol, etc. to be removed, as well as exhausting equipment, condensation equipment, and heating temperature. In this case, it is difficult to accurately know the amount of alcohol to be removed, but it is desirable to remove about 80 mass% or more of the produced alcohol, etc.

Next, the acid catalyst used in the hydrolysis condensation may be removed from the reaction mixture. As a method for removing the acid catalyst, the polysiloxane solution is mixed with water, and the polysiloxane is extracted with an organic solvent. Preferably, the organic solvent used in this event is capable of dissolving the polysiloxane, and achieves two-layer separation when mixed with water. Specific examples of the organic solvent include methanol, ethanol, 1-propanol, 2-propanol, 1-butanol, 2-butanol, 2-methyl-1-propanol, acetone, tetrahydrofuran, toluene, hexane, ethyl acetate, cyclohexanone, methyl amyl ketone, butanediol monomethyl ether, propylene glycol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, ethylene glycol monopropyl ether, propylene glycol dimethyl ether, diethylene glycol dimethyl ether, propylene glycol monomethyl ether acetate, propylene glycol monoethyl ether acetate, ethyl pyruvate, butyl acetate, methyl 3-methoxypropionate, ethyl 3-ethoxypropionate, t-butyl acetate, t-butyl propionate, propylene glycol mono-t-butyl ether acetate, γ-butyrolactone, methyl isobutyl ketone, cyclopentyl methyl ether, mixtures thereof, and the like.

Further, it is also possible to use a mixture of a water-soluble organic solvent and a slightly-water-soluble organic solvent. Preferable examples of the mixture include the mixture of methanol and ethyl acetate, the mixture of ethanol and ethyl acetate, the mixture of 1-propanol and ethyl acetate, the mixture of 2-propanol and ethyl acetate, the mixture of butanediol monomethyl ether and ethyl acetate mixture, the mixture of propylene glycol monomethyl ether and ethyl acetate, the mixture of ethylene glycol monomethyl ether and ethyl acetate, the mixture of butanediol monoethyl ether and ethyl acetate, the mixture of propylene glycol monoethyl ether and ethyl acetate, the mixture of ethylene glycol monoethyl ether and ethyl acetate, the mixture of butanediol monopropyl ether and ethyl acetate, the mixture of propylene glycol monopropyl ether and ethyl acetate, the mixture of ethylene glycol monopropyl ether and ethyl acetate, the mixture of methanol and methyl isobutyl ketone, the mixture of ethanol and methyl isobutyl ketone, the mixture of 1-propanol and methyl isobutyl ketone, the mixture of 2-propanol and methyl isobutyl ketone, the mixture of propylene glycol monomethyl ether and methyl isobutyl ketone, the mixture of ethylene glycol monomethyl ether and methyl isobutyl ketone, the mixture of propylene glycol monoethyl ether and methyl isobutyl ketone, the mixture of ethylene glycol monoethyl ether and methyl isobutyl ketone, the mixture of propylene glycol monopropyl ether and methyl isobutyl ketone, the mixture of ethylene glycol monopropyl ether and methyl isobutyl ketone, the mixture of methanol and cyclopentyl methyl ether, the mixture of ethanol and cyclopentyl methyl ether, the mixture of 1-propanol and cyclopentyl methyl ether, the mixture of 2-propanol and cyclopentyl methyl ether, the mixture of propylene glycol monomethyl ether and cyclopentyl methyl ether, the mixture of ethylene glycol monomethyl ether and cyclopentyl methyl ether, the mixture of propylene glycol monoethyl ether and cyclopentyl methyl ether, the mixture of ethylene glycol monoethyl ether and cyclopentyl methyl ether, the mixture of propylene glycol monopropyl ether and cyclopentyl methyl ether, the mixture of ethylene glycol monopropyl ether and cyclopentyl methyl ether, the mixture of methanol and propylene glycol methyl ether acetate, the mixture of ethanol and propylene glycol methyl ether acetate, the mixture of 1-propanol and propylene glycol methyl ether acetate, the mixture of 2-propanol and propylene glycol methyl ether acetate, the mixture of propylene glycol monomethyl ether and propylene glycol methyl ether acetate, the mixture of ethylene glycol monomethyl ether and propylene glycol methyl ether acetate, the mixture of propylene glycol monoethyl ether and propylene glycol methyl ether acetate, the mixture of ethylene glycol monoethyl ether and propylene glycol methyl ether acetate, the mixture of propylene glycol monopropyl ether and propylene glycol methyl ether acetate, the mixture of ethylene glycol monopropyl ether and propylene glycol methyl ether acetate, and the like. However, the combination is not limited thereto.

Although the mixing ratio of the water-soluble organic solvent and the slightly-water-soluble organic solvent is appropriately selected, the amount of the water-soluble organic solvent may be, for example, 0.1 to 1,000 parts by mass, preferably 1 to 500 parts by mass, further preferably 2 to 100 parts by mass, based on 100 parts by mass of the slightly-water-soluble organic solvent.

Subsequently, the thermally crosslinking polysiloxane solution may be washed with neutral water. As the water, what is commonly called deionized water or ultrapure water may be used. The amount of the water is preferably 0.01 to 100 L, more preferably 0.05 to 50 L, and further preferably 0.1 to 5 L, relative to 1 L of the thermally crosslinking polysiloxane solution. This washing procedure may be performed by putting both the thermally crosslinking polysiloxane solution and neutral water into the same container, followed by stirring and then leaving to stand to separate the aqueous layer. The washing may be performed once or more, preferably once to approximately five times, since washing ten times or more does not always produce the full washing effects thereof.

Other methods for removing the acid catalyst include a method using an ion-exchange resin, and a method in which the acid catalyst is removed after neutralization with an epoxy compound such as ethylene oxide and propylene oxide. These methods can be appropriately selected in accordance with the acid catalyst used in the reaction.

In this water-washing operation, part of the thermally crosslinking polysiloxane escapes into the aqueous layer, so that substantially the same effect as fractionation operation is obtained in some cases. Hence, the number of water-washing operations and the amount of washing water may be appropriately selected in view of the catalyst removal effect and the fractionation effect.

To either of a solution of the polysiloxane with the acid catalyst still remaining or a solution of the polysiloxane with the acid catalyst having been removed, a final solvent may be added for solvent exchange under reduced pressure to obtain a desired polysiloxane solution. In this event, the temperature during the solvent exchange is preferably 0 to 100°C, more preferably 10 to 90°C, further preferably 15 to 80°C, depending on the kinds of the reaction solvent and the extraction solvent to be removed. Moreover, the degree of vacuum in this event is preferably atmospheric pressure or less, more preferably 80 kPa or less in absolute pressure, further preferably 50 kPa or less in absolute pressure, although the degree of vacuum varies depending on the kinds of the extraction solvent to be removed, exhausting equipment, condensation equipment, and heating temperature.

In this event, the thermally crosslinking polysiloxane may become unstable due to the solvent exchange. This occurs due to incompatibility of the polysiloxane with the final solvent. Thus, in order to prevent this phenomenon, a monohydric, dihydric, or polyhydric alcohol having cyclic ether as a substituent as shown in paragraphs [0181] and [0182] of JP2009-126940A may be added as a stabilizer. The alcohol may be added in an amount of, for example, 0 to 25 parts by mass, preferably 0 to 15 parts by mass, more preferably 0 to 5 parts by mass, based on 100 parts by mass of the thermally crosslinking polysiloxane in the solution before the solvent exchange. When the alcohol is added, the amount is preferably 0.5 parts by mass or more. If necessary, the monohydric, dihydric, or polyhydric alcohol having cyclic ether as a substituent may be added to the solution before the solvent exchange, and then the solvent exchange operation may be performed.

If the polysiloxane is concentrated above a certain concentration, the condensation reaction may further progress, so that the polysiloxane becomes no longer soluble in an organic solvent. Thus, it is preferable to maintain the solution state with a proper concentration. Meanwhile, if the concentration is too low, the amount of solvent is excessive. Hence, the solution state with a proper concentration is economical and preferable. The concentration in this state is preferably 0.1 to 20 mass%.

The final solvent added to the thermally crosslinking polysiloxane solution is preferably an alcohol-based solvent. Particularly preferable examples include monoalkyl ether derivatives of ethylene glycol, diethylene glycol, triethylene glycol, propylene glycol, dipropylene glycol, butanediol, or the like. Specific examples include butanediol monomethyl ether, propylene glycol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, ethylene glycol monopropyl ether, diacetone alcohol, and the like.

When these solvents are used as the main component, a non-alcohol-based solvent can also be added as an adjuvant solvent. Examples of the adjuvant solvent include acetone, tetrahydrofuran, toluene, hexane, ethyl acetate, cyclohexanone, methyl amyl ketone, propylene glycol dimethyl ether, diethylene glycol dimethyl ether, propylene glycol monomethyl ether acetate, propylene glycol monoethyl ether acetate, ethyl pyruvate, butyl acetate, methyl 3-methoxypropionate, ethyl 3-ethoxypropionate, t-butyl acetate, t-butyl propionate, propylene glycol mono-t-butyl ether acetate, γ-butyrolactone, methyl isobutyl ketone, cyclopentyl methyl ether, and the like.

As an alternative reaction operation using an acid catalyst, water or a water-containing organic solvent may be added to the monomer or an organic solution of the monomer to initiate the hydrolysis reaction. In this event, the catalyst may be added to the monomer or the organic solution of the monomer, or may be added to the water or the water-containing organic solvent. The reaction temperature may be, for example, 0 to 100°C, preferably 10 to 80°C. As a preferable method, when the water is added dropwise, the mixture is heated to 10 to 50°C, and then further heated to 20 to 80°C for aging.

When the organic solvent is used, a water-soluble solvent is preferable. Examples thereof include methanol, ethanol, 1-propanol, 2-propanol, 1-butanol, 2-butanol, 2-methyl-1-propanol, acetone, tetrahydrofuran, and acetonitrile; polyhydric alcohol condensate derivatives, such as butanediol monomethyl ether, propylene glycol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, ethylene glycol monopropyl ether, propylene glycol dimethyl ether, diethylene glycol dimethyl ether, propylene glycol monomethyl ether acetate, propylene glycol monoethyl ether acetate, and propylene glycol monopropyl ether; mixtures thereof, and the like.

The organic solvent can be used in an amount of, for example, 0 to 1,000 ml, particularly preferably 0 to 500 ml, relative to 1 mol of the monomer. When the organic solvent is used in a small amount, only a small reaction vessel is required, and this is economical. The obtained reaction mixture may be subjected to posttreatment by the same procedure as described above to obtain a polysiloxane.

### (Synthesis Method 2: Alkali Catalyst)

Alternatively, the polysiloxane (Sx) can also be produced by the hydrolysis condensation of one kind of the hydrolysable monomer (Sm) or a mixture of two or more kinds thereof in the presence of an alkali catalyst.

Examples of the alkali catalyst used in this event include methylamine, ethylamine, propylamine, butylamine, ethylenediamine, hexamethylenediamine, dimethylamine, diethylamine, ethylmethylamine, trimethylamine, triethylamine, tripropylamine, tributylamine, cyclohexylamine, dicyclohexylamine, monoethanolamine, diethanolamine, dimethyl monoethanolamine, monomethyl diethanolamine, triethanolamine, diazabicyclooctane, diazabicyclocyclononene, diazabicycloundecene, hexamethylenetetramine, aniline, N,N-dimethylaniline, pyridine, N,N-dimethylaminopyridine, pyrrole, piperazine, pyrrolidine, piperidine, picoline, tetramethylammonium hydroxide, choline hydroxide, tetrapropylammonium hydroxide, tetrabutylammonium hydroxide, ammonia, lithium hydroxide, sodium hydroxide, potassium hydroxide, barium hydroxide, calcium hydroxide, and the like. The catalyst can be used in an amount of, for example, 1×10⁻⁶ mol to 10 mol, preferably 1×10⁻⁵ mol to 5 mol, more preferably 1×10⁻⁴ mol to 1 mol, relative to 1 mol of the silicon monomer.

When the thermally crosslinking polysiloxane is obtained from the monomer by the hydrolysis condensation, water is preferably added in an amount of 0.1 to 50 mol per mol of the hydrolysable substituent bonded to the monomer. When the amount is 50 mol or less, a device used for the reaction can be made small and economical.

As the operation method, for example, the monomer is added to an aqueous solution of a catalyst to initiate the hydrolysis condensation reaction. In this event, an organic solvent may be added to the aqueous solution of the catalyst, or the monomer may be diluted with an organic solvent, or both of these operations may be performed. The reaction temperature may be, for example, 0 to 100°C, preferably 5 to 80°C. As a preferable method, when the monomer is added dropwise, the temperature is maintained at 5 to 80°C, and then the mixture is aged at 20 to 80°C.

As the organic solvent which can be added to the aqueous alkali catalyst solution or with which the monomer can be diluted, the same organic solvents as those exemplified as the organic solvents which can be added to the aqueous solution of the acid catalyst are preferably used. Note that the organic solvent is used in an amount of preferably 0 to 1,000 ml relative to 1 mol of the monomer because the reaction can be performed economically.

Then, if necessary, neutralization reaction of the catalyst is carried out to obtain an aqueous solution of the reaction mixture. In this event, the amount of an acidic substance usable for the neutralization is preferably 0.1 to 2 equivalents relative to the alkaline substance used as the catalyst. This acidic substance may be any substance as long as it exhibits acidity in water.

Subsequently, by-products such as alcohol produced by the hydrolysis condensation reaction are preferably removed from the reaction mixture by a procedure such as removal under reduced pressure. In this event, the reaction mixture is heated at a temperature of preferably 0 to 100°C, more preferably 10 to 90°C, further preferably 15 to 80°C, although the temperature depends on the kinds of the added organic solvent and alcohol produced in the reaction. Moreover, the degree of vacuum in this event is preferably atmospheric pressure or less, more preferably 80 kPa or less in absolute pressure, further preferably 50 kPa or less in absolute pressure, although the degree of vacuum varies depending on the kinds of the organic solvent and alcohol to be removed, as well as exhausting equipment, condensation equipment, and heating temperature. In this case, it is difficult to accurately know the amount of alcohol to be removed, but it is desirable to remove about 80 mass% or more of the produced alcohol.

Next, to remove the alkali catalyst used in the hydrolysis condensation, the polysiloxane is extracted with an organic solvent. Preferably, the organic solvent used in this event is capable of dissolving the polysiloxane, and achieves two-layer separation when mixed with water. Examples of the organic solvent include methanol, ethanol, 1-propanol, 2-propanol, 1-butanol, 2-butanol, 2-methyl-1-propanol, acetone, tetrahydrofuran, toluene, hexane, ethyl acetate, cyclohexanone, methyl amyl ketone, propylene glycol monomethyl ether, ethylene glycol monomethyl ether, propylene glycol monoethyl ether, ethylene glycol monoethyl ether, propylene glycol monopropyl ether, ethylene glycol monopropyl ether, propylene glycol dimethyl ether, diethylene glycol dimethyl ether, propylene glycol monomethyl ether acetate, propylene glycol monoethyl ether acetate, ethyl pyruvate, butyl acetate, methyl 3-methoxypropionate, ethyl 3-ethoxypropionate, t-butyl acetate, t-butyl propionate, propylene glycol mono-t-butyl ether acetate, γ-butyrolactone, methyl isobutyl ketone, cyclopentyl methyl ether, and the like, and mixtures thereof.

Further, it is also possible to use a mixture of a water-soluble organic solvent and a slightly-water-soluble organic solvent.

As concrete examples of the organic solvent used for removing the alkali catalyst, it is possible to use the same organic solvents or the same mixture of the water-soluble organic solvent and the water-insoluble organic solvent as those specifically exemplified for the acid catalyst removal described above.

Although the mixing ratio of the water-soluble organic solvent and the slightly-water-soluble organic solvent is appropriately selected, the amount of the water-soluble organic solvent may be, for example, 0.1 to 1,000 parts by mass, preferably 1 to 500 parts by mass, further preferably 2 to 100 parts by mass, based on 100 parts by mass of the slightly-water-soluble organic solvent.

Subsequently, the thermally crosslinking polysiloxane solution may be washed with neutral water. As the water, what is commonly called deionized water or ultrapure water may be used. The amount of the water is, for example, 0.01 to 100 L, preferably 0.05 to 50 L, more preferably 0.1 to 5 L, relative to 1 L of the thermally crosslinking polysiloxane solution. This washing procedure may be performed by putting both the thermally crosslinking polysiloxane solution and neutral water into the same container, followed by stirring and then leaving to stand to separate the aqueous layer. The washing may be performed once or more, preferably once to approximately five times, since washing ten times or more does not always produce the full washing effects thereof.

To the washed polysiloxane solution, a final solvent may be added for solvent exchange under reduced pressure to obtain a desired polysiloxane solution. In this event, the temperature during the solvent exchange is preferably 0 to 100°C, more preferably 10 to 90°C, further preferably 15 to 80°C, depending on the kinds of the extraction solvent to be removed. Moreover, the degree of vacuum in this event is preferably atmospheric pressure or less, more preferably 80 kPa or less in absolute pressure, further preferably 50 kPa or less in absolute pressure, although the degree of vacuum varies depending on the kinds of the extraction solvent to be removed, exhausting equipment, condensation equipment, and heating temperature.

The final solvent added to the polysiloxane solution is preferably an alcohol-based solvent. Particularly preferable alcohol-based solvents include monoalkyl ethers of ethylene glycol, diethylene glycol, triethylene glycol, and the like, and monoalkyl ethers of propylene glycol, dipropylene glycol, and the like. Specifically, preferable examples include propylene glycol monomethyl ether, ethylene glycol monomethyl ether, propylene glycol monoethyl ether, ethylene glycol monoethyl ether, propylene glycol monopropyl ether, ethylene glycol monopropyl ether, diacetone alcohol, and the like.

As an alternative reaction operation using an alkali catalyst, for example, water or a water-containing organic solvent is added to the monomer or an organic solution of the monomer to initiate the hydrolysis reaction. In this event, the catalyst may be added to the monomer or the organic solution of the monomer, or may be added to the water or the water-containing organic solvent. The reaction temperature may be, for example, 0 to 100°C, preferably 10 to 80°C. As a preferable method, when the water is added dropwise, the mixture is heated to 10 to 50°C, and then further heated to 20 to 80°C for aging.

The organic solvent usable for the organic solution of the monomer or the water-containing organic solvent is preferably a water-soluble solvent. Examples thereof include methanol, ethanol, 1-propanol, 2-propanol, 1-butanol, 2-butanol, and 2-methyl-1-propanol, acetone, tetrahydrofuran, acetonitrile; polyhydric alcohol condensate derivatives, such as propylene glycol monomethyl ether, ethylene glycol monomethyl ether, propylene glycol monoethyl ether, ethylene glycol monoethyl ether, propylene glycol monopropyl ether, ethylene glycol monopropyl ether, propylene glycol dimethyl ether, diethylene glycol dimethyl ether, propylene glycol monomethyl ether acetate, propylene glycol monoethyl ether acetate, and propylene glycol monopropyl ether; mixtures thereof, and the like.

The molecular weight of the polysiloxane obtained by the above synthesis method 1 or 2 can be adjusted not only through the selection of the monomers, but also through the control of the reaction condition during the polymerization, and the polysiloxane preferably has a weight-average molecular weight of 100,000 or less, more preferably 200 to 50,000, further preferably 300 to 30,000. When the weight-average molecular weight is 100,000 or less, the generation of foreign matters or coating spots does not occur. Regarding data on the weight-average molecular weight, the molecular weight is expressed in terms of polystyrene which is obtained by gel permeation chromatography (GPC) using a refractive index (RI) detector, tetrahydrofuran as an eluent, and polystyrene as a reference substance.

The physical properties of the thermally crosslinking polysiloxane used in the present invention vary depending on the kind of acid or alkali catalyst and reaction conditions adopted in the hydrolysis condensation. Therefore, the physical properties of the thermally crosslinking polysiloxane can be selected appropriately in accordance with the target performance of the resist underlayer film.

Furthermore, it is possible to use, as a component of a composition for forming a resist underlayer film, a polysiloxane derivative produced from a mixture of one or more kinds of the hydrolysable monomer (Sm) and a hydrolysable metal compound represented by the following general formula (Mm) under conditions using the acid or alkali catalyst.

**U(OR⁷)ₘ₇(OR⁸)ₘ₈** **(Mm)**

In the formula, R⁷ and R⁸ each independently represent an organic group having 1 to 30 carbon atoms; m7 + m8 is the same number as a valence determined by the kind of U; m7 and m8 each represent an integer of 0 or more; and U represents an element belonging to the group III, IV, or V in the periodic table, other than carbon and silicon.

Examples of the hydrolysable metal compound represented by the general formula (Mm) include metal alkoxides including boron, aluminum, gallium, yttrium, germanium, titanium, hafnium, etc. Specifically, those disclosed in [0107] to [0123] of JP2020-118960A are usable.

### (Crosslinking Agent)

A crosslinking agent is added to the composition for forming a silicon-containing antireflective film used in the inventive patterning process in order to increase the density of the antireflective film and enhance the poisoning-suppression effect of preventing the basic components that may be generated from the silicon-containing hard mask from moving to the photoresist film and causing the degradation of the sensitivity and resolution of the resist.

The crosslinking agent is not particularly limited, and various known crosslinking agents can be widely used. Examples include melamine-based crosslinking agents, glycoluril-based crosslinking agents, benzoguanamine-based crosslinking agents, urea-based crosslinking agents, β-hydroxyalkylamide-based crosslinking agents, isocyanurate-based crosslinking agents, aziridine-based crosslinking agents, oxazoline-based crosslinking agents, epoxy-based crosslinking agents, and phenol-based crosslinking agents. One kind of the crosslinking agent can be used, or two or more kinds thereof can be used in combination, and when the crosslinking agent is to be added, the added amount is preferably 5 to 50 parts, more preferably 10 to 40 parts, and further preferably 10 to 30 parts based on 100 parts of the composition for forming a silicon-containing antireflective film. When the contained amount is 5 parts or more, sufficient curability can be exhibited, and poisoning into the photoresist film can be suppressed. Meanwhile, when the added amount is 50 parts or less, there is no risk of degradation in dry etching resistance due to the proportion of the silicon in the composition being low.

The crosslinking agent is preferably a compound including an isocyanuric acid structure, and more preferably has a structure of the following formula (A-1) . 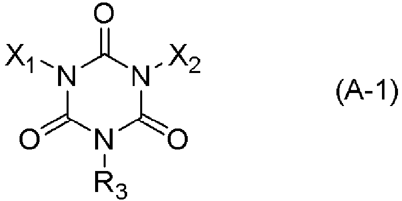 In the formula, X₁, X₂, and R₃ each independently represent a methyl group, an ethyl group, a propyl group, an allyl group, a propargyl group, or a group represented by the following formula (A-2). 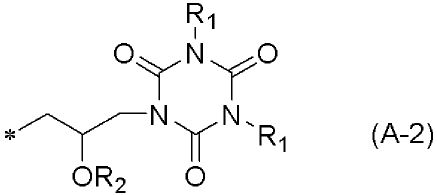 In the formula, R₁ represents a methyl group, an ethyl group, a propyl group, an allyl group, or a propargyl group; R₂ represents a hydrogen atom, an acetyl group, an acryloyl group, a methacryloyl group, a benzoyl group, a naphthoyl group, or an anthranoyl group; and "*" represents an attachment point.

When the crosslinking agent is a compound containing the above-described structure, the crosslinking agent can be crosslinked with the polysiloxane by baking when added to the composition for forming a silicon-containing antireflective film, and can form a dense film. Thus, it is possible to form a silicon-containing antireflective film (C) that exhibits an excellent poisoning-suppression effect. Moreover, the crosslinking agent can further improve adhesiveness to the photoresist film (resist upper layer film), and makes it possible to form a resist pattern having a higher effect of suppressing ultrafine-pattern collapse and a better pattern shape.

Specific examples of preferable structures include the following structures. R₃ is as defined above.

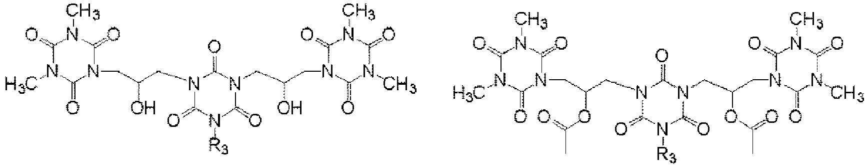

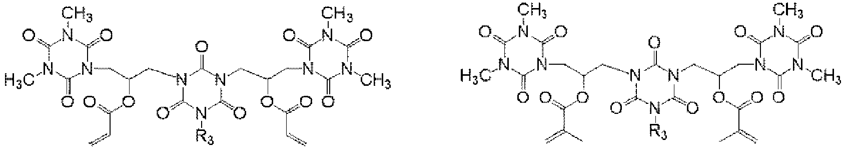

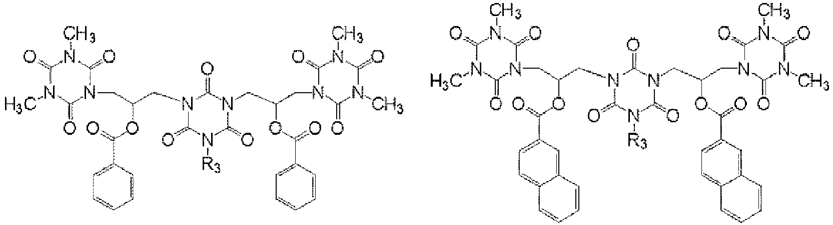

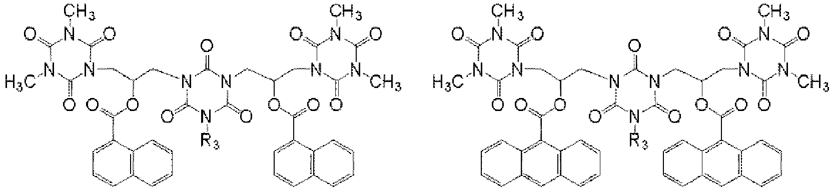

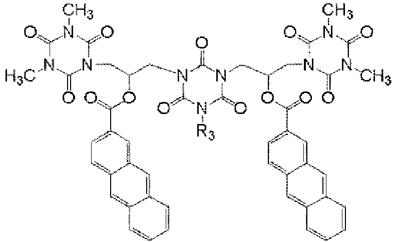

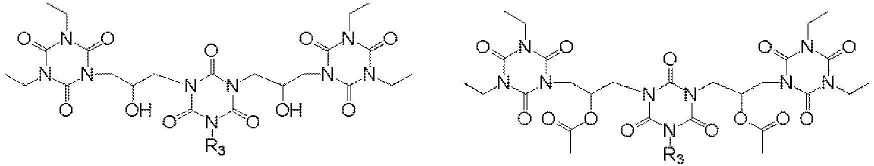

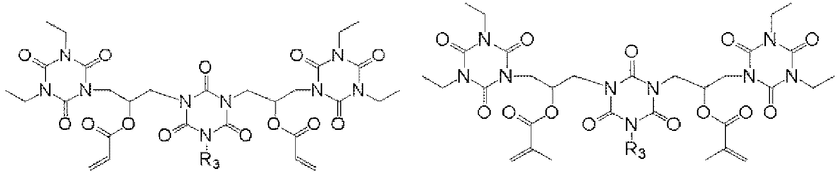

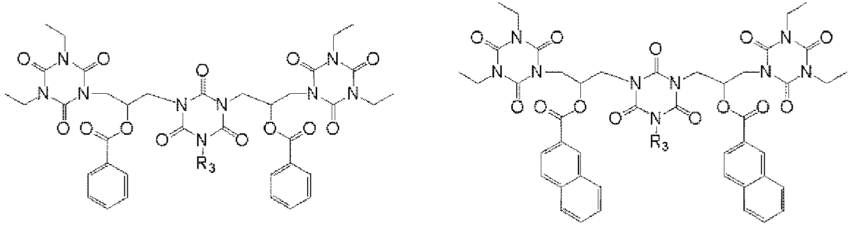

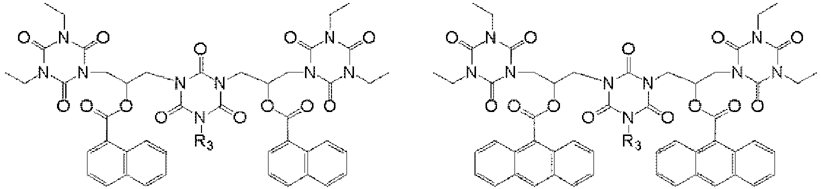

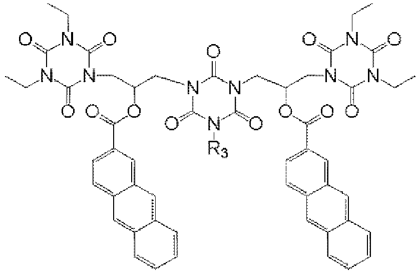

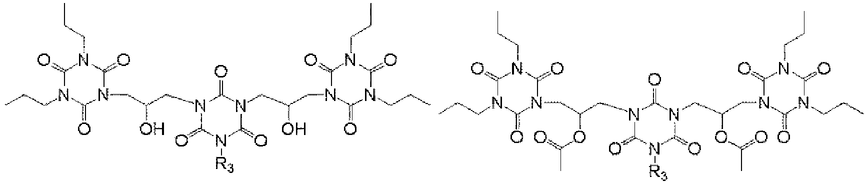

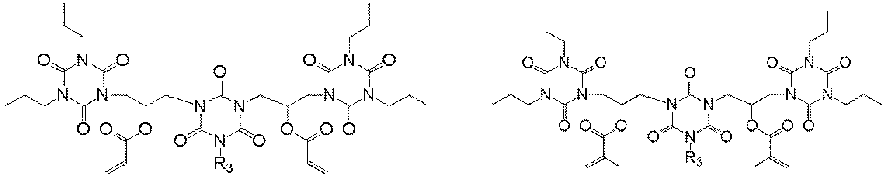

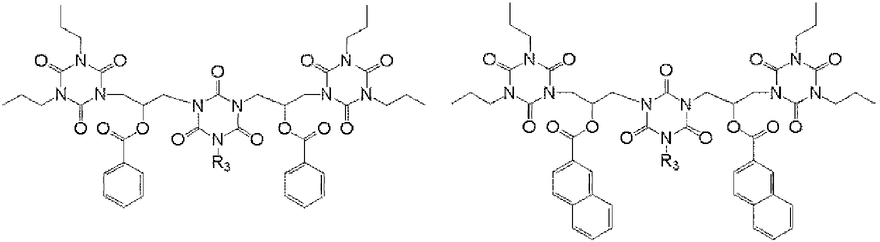

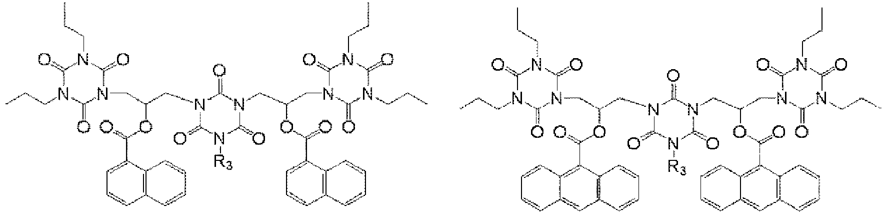

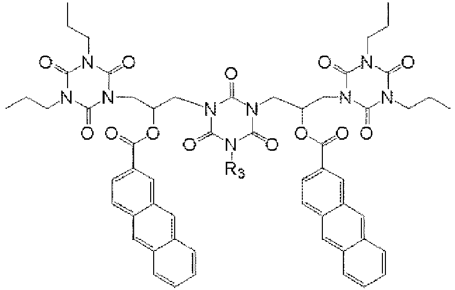

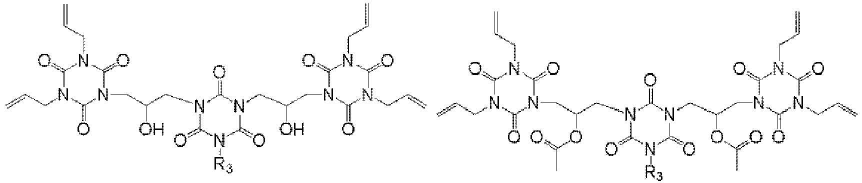

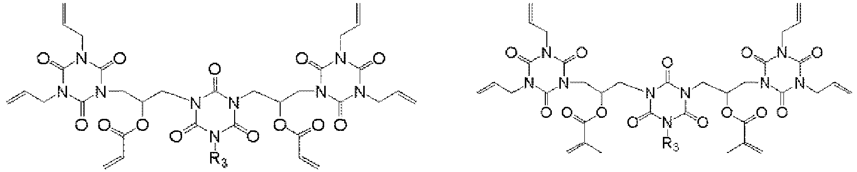

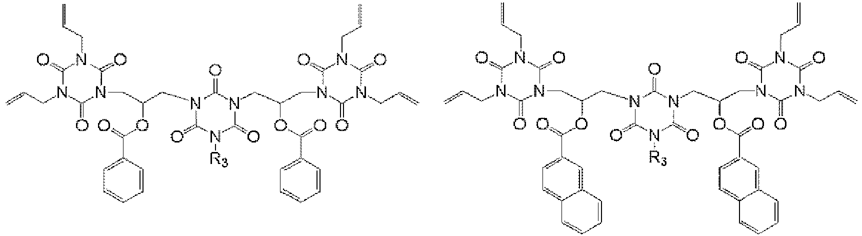

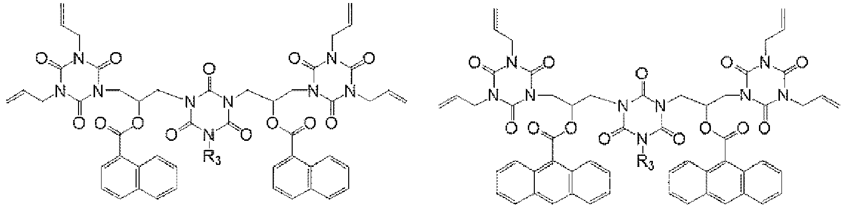

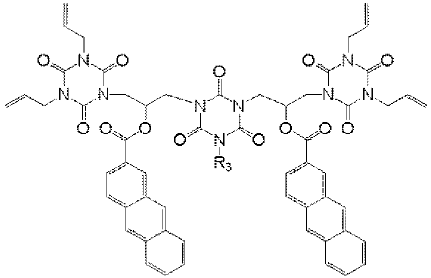

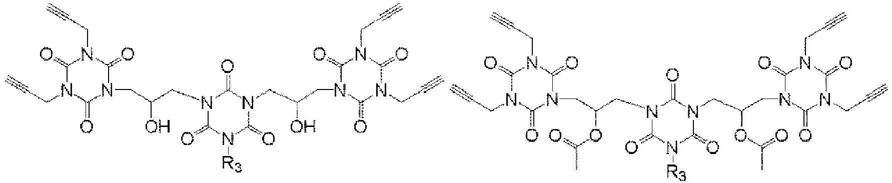

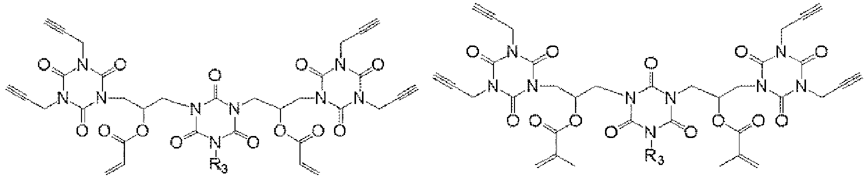

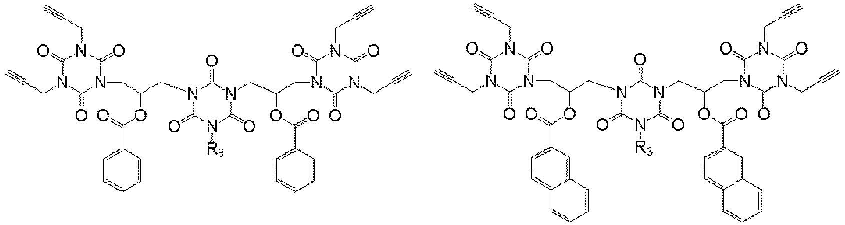

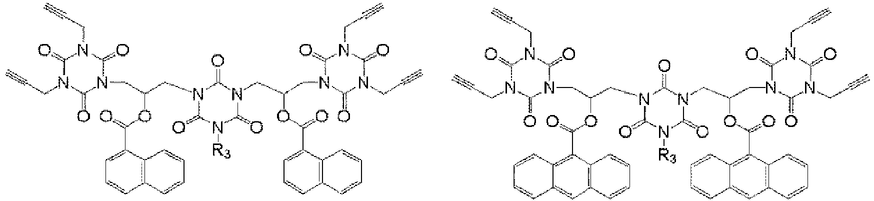

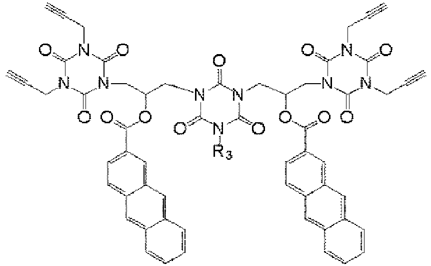

Examples of the structure represented by the general formula (A-2) include the following.

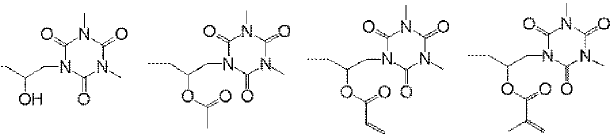

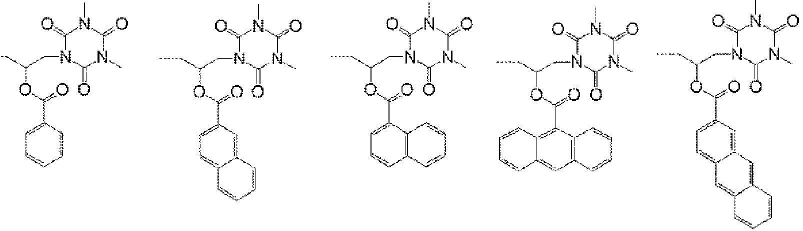

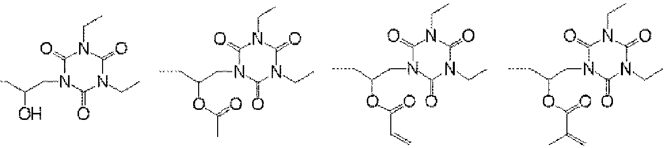

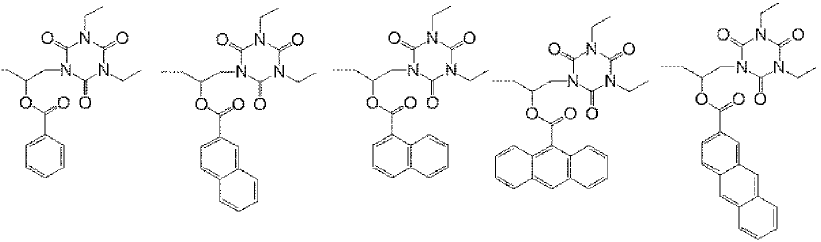

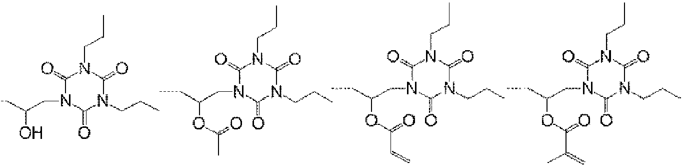

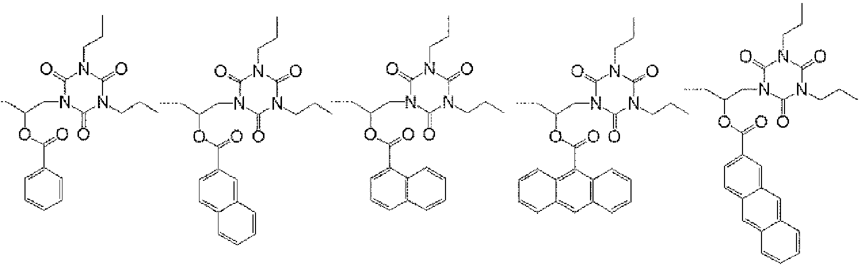

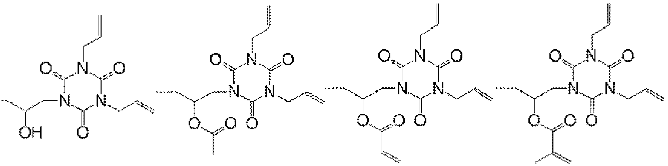

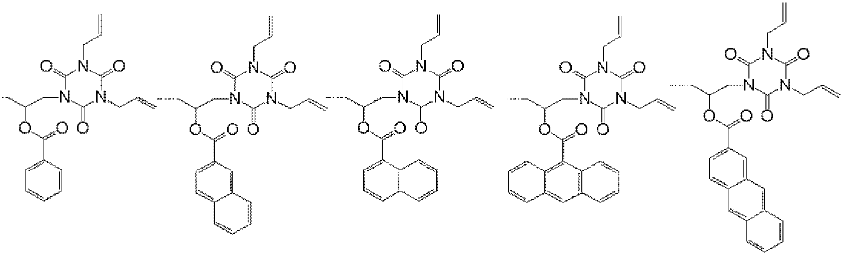

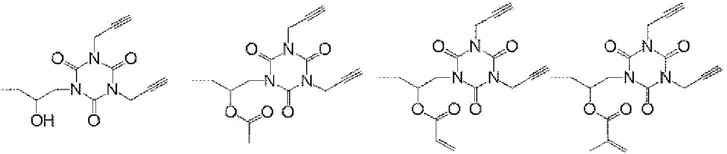

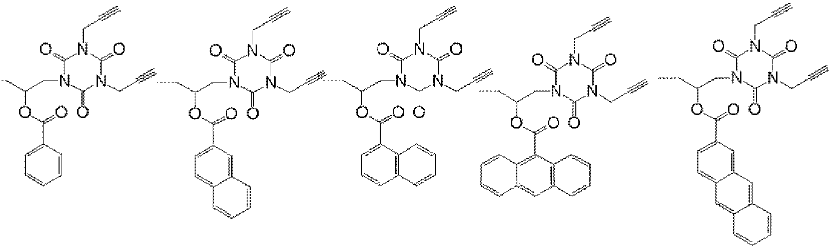

Preferable examples of the compound represented by the general formula (A-1) include the following. Specifically, R₁ is preferably an allyl group or a propargyl group, R₂ is preferably a hydrogen atom, an acetyl group, or an acryl group, and R₃ is preferably an allyl group or a group represented by the general formula (A-2); and R₁ is further preferably an allyl group or a propargyl group, R₂ is further preferably a hydrogen atom or an acetyl group, and R₃ is further preferably an allyl group.

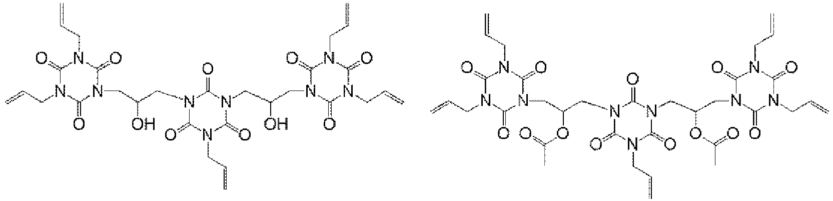

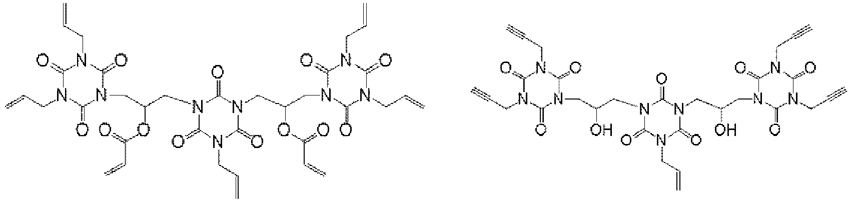

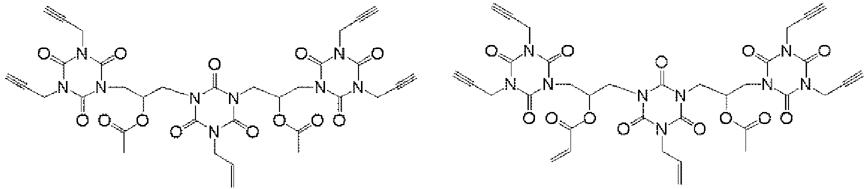

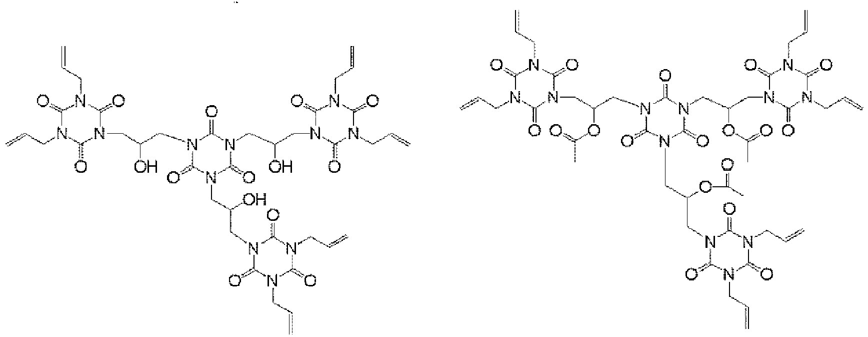

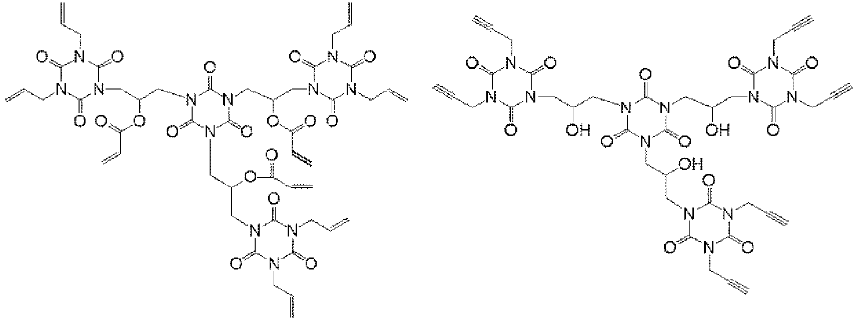

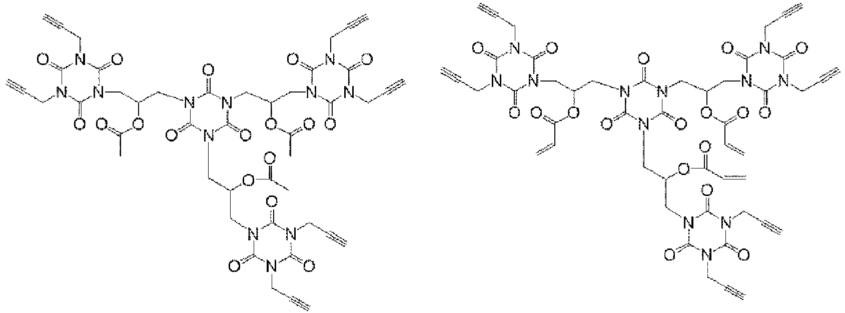

### (Acid Generator)

The composition for forming a silicon-containing antireflective film used in the inventive patterning process may further contain one or more acid generators. As the acid generator, any substance may be used, for example, a thermal acid generator, a photo-acid generator, or an acid amplifier, as long as the substance functions as an acid precursor. In the present invention, it is more preferable that the acid generator to be contained is a sulfonium salt and is a photo-acid generator, which generates an acid by the action of a high-energy beam. Specifically, it is possible to add a material disclosed in paragraphs [0061] to [0085] of JP2007-199653A, but the acid generator is not limited thereto.

One kind of the acid generator may be used, or two or more kinds thereof may be used in combination. When the acid generator is to be added, the added amount is preferably 0.05 to 50 parts, more preferably 0.1 to 10 parts based on 100 parts of the thermally crosslinking polysiloxane.

### [Other Components]

### (Crosslinking Catalyst)

In the present invention, the composition for forming a silicon-containing antireflective film may contain a crosslinking catalyst (Xc). Examples of crosslinking catalysts that can be added include compounds represented by the following general formula (Xc0) .

LₐH_{b}A (Xc0)

In the formula, L represents lithium, sodium, potassium, rubidium, cesium, sulfonium, iodonium, phosphonium, or ammonium; A represents a non-nucleophilic counter ion; "a" represents an integer of 1 or more; "b" represents 0 or an integer of 1 or more; and a + b is a valence of the non-nucleophilic counter ion.

Specific examples of crosslinking catalysts that may be used in the present invention as (Xc0) include sulfonium salts of the following general formula (Xc-1), iodonium salts of the following general formula (Xc-2), phosphonium salts of the following general formula (Xc-3), ammonium salts of the following general formula (Xc-4), alkaline metal salts, etc. and polysiloxanes (Xc-10) having an ammonium salt, a sulfonium salt, a phosphonium salt, or an iodonium salt as part of the structure. Specifically, it is possible to add a material disclosed in paragraphs [0124] to [0163] in JP2020-118960A, etc.

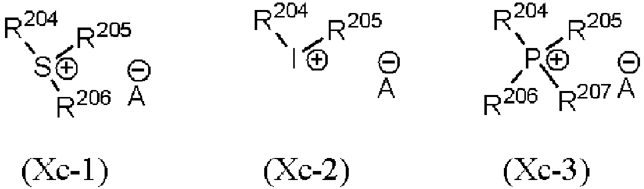

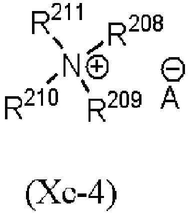

In the formulae, R²⁰⁴, R²⁰⁵, R²⁰⁶, and R²⁰⁷ each represent a linear, branched, or cyclic alkyl group, alkenyl group, oxoalkyl group, or oxoalkenyl group having 1 to 12 carbon atoms, a substituted or unsubstituted aryl group having 6 to 20 carbon atoms, or an aralkyl group or aryloxoalkyl group having 7 to 12 carbon atoms; part or all of the hydrogen atoms of these groups are optionally substituted with an alkoxy group or the like. Additionally, R²⁰⁵ and R²⁰⁶ may form a ring; when a ring is formed, R²⁰⁵ and R²⁰⁶ each represent an alkylene group having 1 to 6 carbon atoms. A⁻ represents a non-nucleophilic counter ion. R²⁰⁸, R²⁰⁹, R²¹⁰, and R²¹¹ are the same as R²⁰⁴, R²⁰⁵, R²⁰⁶, and R²⁰⁷, or may be each a hydrogen atom. R²⁰⁸ and R²⁰⁹, or R²⁰⁸, R²⁰⁹ and R²¹⁰ may form a ring; when a ring is formed, R²⁰⁸ and R²⁰⁹, or R²⁰⁸, R²⁰⁹ and R²¹⁰, represent an alkylene group having 3 to 10 carbon atoms.

One kind of the crosslinking catalysts (Xc-1), (Xc-2), (Xc-3), (Xc-4), and (Xc-10) may be used, or two or more kinds thereof may be used in combination. The amount of the crosslinking catalyst to be added is preferably 0.01 to 50 parts by mass, more preferably 0.1 to 40 parts by mass based on 100 parts by mass of the base polymer (e.g. the thermally crosslinking polysiloxane (Sx) obtained by a method described above).

The composition for forming a silicon-containing antireflective film used in the inventive patterning process may further contain the following raw materials.

### (Organic Acid)

To improve the stability of the composition for forming a silicon-containing antireflective film to be used in the inventive patterning process, it is preferable to add a monovalent, divalent, or polyvalent organic acid having 1 to 30 carbon atoms. Examples of the acid added in this event include formic acid, acetic acid, propionic acid, butanoic acid, pentanoic acid, hexanoic acid, heptanoic acid, octanoic acid, nonanoic acid, decanoic acid, oleic acid, stearic acid, linoleic acid, linolenic acid, benzoic acid, phthalic acid, isophthalic acid, terephthalic acid, salicylic acid, trifluoroacetic acid, monochloroacetic acid, dichloroacetic acid, trichloroacetic acid, oxalic acid, malonic acid, methylmalonic acid, ethylmalonic acid, propylmalonic acid, butylmalonic acid, dimethylmalonic acid, diethylmalonic acid, succinic acid, methylsuccinic acid, glutaric acid, adipic acid, itaconic acid, maleic acid, fumaric acid, citraconic acid, citric acid, and the like. Particularly, oxalic acid, maleic acid, formic acid, acetic acid, propionic acid, citric acid, and the like are preferable. Moreover, a mixture of two or more acids may be used to keep the stability.

The amount of the organic acid to be added may be, for example, 0.001 to 25 parts by mass, preferably 0.01 to 15 parts by mass, more preferably 0.1 to 5 parts by mass, based on 100 parts by mass of the thermally crosslinking polysiloxane contained in the composition for forming a silicon-containing antireflective film used in the inventive patterning process.

Otherwise, the organic acid(s) may be blended based on the pH of the composition for forming a silicon-containing antireflective film to be used in the inventive patterning process so as to satisfy preferably 0 ≤ pH ≤ 7, more preferably 0.3 ≤ pH ≤ 6.5, further preferably 0.5 ≤ pH ≤ 6.

### (Water)

In the present invention, water may be added to the composition for forming a silicon-containing antireflective film. When water is added, the polysiloxane compound in the composition for forming a silicon-containing antireflective film to be used in the inventive patterning process is hydrated, so that the lithography performance is improved. The water content in the solvent component of the composition for forming a silicon-containing antireflective film used in the inventive patterning process is preferably more than 0 mass% and less than 50 mass%, particularly preferably 0.3 to 30 mass%, further preferably 0.5 to 20 mass%. When the amount of water added is within such ranges, the uniformity of the silicon-containing antireflective film is excellent, and there is no risk of repellence occurring or of lithography performance being degraded.

The solvent including water can be used in a total amount of, for example, 100 to 100,000 parts by mass, particularly preferably 200 to 50,000 parts by mass, based on 100 parts by mass of the polysiloxane (Sx), which is the base polymer.

### (Stabilizer)

Further, in the present invention, a stabilizer can be added to the composition for forming a silicon-containing antireflective film. As the stabilizer, a monohydric, dihydric, or polyhydric alcohol having a cyclic ether substituent can be added, for example. Particularly, adding stabilizers shown in paragraphs [0181] and [0182] of JP2009-126940A enables stability improvement of the composition for forming a silicon-containing antireflective film.

The amount of the stabilizer to be added can be, for example, 0.001 to 50 parts by mass, particularly preferably 0.01 to 40 parts by mass, based on 100 parts by mass of the polysiloxane (Sx), which is the base polymer.

### (Surfactant)

Further, in the present invention, a surfactant can be blended into the composition for forming a silicon-containing antireflective film as necessary. Specifically, the materials described in paragraph [0185] of JP2009-126940A can be added as the surfactant.

The amount of the surfactant to be added can be, for example, 0.001 to 5 parts by mass, particularly preferably 0.01 to 1 parts by mass, based on 100 parts by mass of the polysiloxane (Sx), which is the base polymer.

### (High-Boiling-Point Solvent)

Further, in the present invention, a high-boiling-point solvent having a boiling point of 180°C or higher can also be added to the composition for forming a silicon-containing antireflective film as necessary. Note that the boiling point herein is a boiling point at standard atmosphere (1013 hPa). Examples of the high-boiling-point solvent include 1-octanol, 2-ethylhexanol, 1-nonanol, 1-decanol, 1-undecanol, ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, glycerin, gamma-butyrolactone, tripropylene glycol monomethyl ether, diacetone alcohol, n-nonyl acetate, ethylene glycol monoethyl ether acetate, 1,2-diacetoxyethane, 1-acetoxy-2-methoxyethane, 1,2-diacetoxypropane, diethylene glycol monomethyl ether acetate, diethylene glycol monoethyl ether acetate, diethylene glycol mono-n-butyl ether acetate, propylene glycol monomethyl ether acetate, propylene glycol monopropyl ether acetate, propylene glycol monobutyl ether acetate, dipropylene glycol monomethyl ether acetate, dipropylene glycol monoethyl ether acetate, and the like.

The amount of the high-boiling-point solvent to be added can be, for example, 5 to 200 parts by mass, particularly preferably 10 to 100 parts by mass, based on 100 parts by mass of the polysiloxane (Sx), which is the base polymer.

The silicon-containing antireflective film (C) can be formed on the silicon-containing hard mask (B), for example, by a spin-coating method or the like, using the above-described composition for forming a silicon-containing antireflective film. After forming the silicon-containing antireflective film (C) by a spin-coating method or the like, it is desirable to bake the film to evaporate the organic solvent. The baking temperature is preferably 100 to 600°C, more preferably 150°C to 350°C. The baking time is preferably 10 to 300 seconds, more preferably 30 seconds to 180 seconds.

The thickness FTc of the silicon-containing antireflective film (C) (layer C) is preferably thinner (FTb > FTc) than the film thickness FTb of the silicon-containing hard mask (B) (layer B), and specifically, the film thickness is preferably 1 to 15 nm, more preferably 1 to 12 nm, and further preferably 1 to 10 nm. That is, it is preferable to form the silicon-containing antireflective film (C) in such a manner that the silicon-containing antireflective film (C) has a film thickness FTc of 15 nm or less.

When the silicon-containing antireflective film has a film thickness in the above range, film loss of the resist pattern can be minimized when the silicon-containing antireflective film (C) is processed by dry etching using a fluorine-based gas while using the resist pattern formed in the photoresist film (D) as a mask. Therefore, in the subsequent step, it is possible to transfer the resist pattern to the silicon-containing hard mask (B) with high precision when the silicon-containing hard mask (B) is processed by dry etching using a fluorine-based gas while using a pattern including the photoresist film (D) and the silicon-containing antireflective film (C) as a mask.

The silicon-containing antireflective film (C) preferably has a silicon content (b) of 5 to 30 mass%, more preferably 5 to 25 mass%, and further preferably 5 to 20 mass% as measured by RBS (Rutherford Backscattering Spectrometry). When the proportion (b) of silicon in the silicon-containing antireflective film (C) is 5 mass% or more, a high-refractive-index film can be formed, and antireflective function can be enhanced. When the silicon content (b) of the silicon-containing antireflective film (C) is 30 mass% or less, the rate of etching with a fluorine-based gas can be prevented from increasing, and the selectivity ratio to the silicon-containing hard mask (B) (layer B) can be enhanced.

According to the above-described manufacturing method, the silicon-containing antireflective film (C) (layer C) has a lower etching rate to fluorine-based gas than that of the silicon-containing hard mask (B) (layer B), and therefore, the resist pattern shape can be transferred to the silicon-containing hard mask (B) (layer B) with high precision.

### <(D) Photoresist Film (Layer D)>

In the inventive patterning process, the photoresist film composition used for forming the photoresist film is not particularly limited, but preferably contains a chemically-amplified photoresist composition. Note that, in the present invention, either positive development using an alkali developer or negative development using an organic solvent developer can be adopted, and therefore, a positive photoresist film material or a negative photoresist film material can be selected appropriately in accordance with the development method.

The thickness of the photoresist film (D) is not particularly limited, but is preferably 10 to 500 nm, particularly preferably 20 to 200 nm.

Furthermore, the photoresist film composition may contain a metal atom such as Sn, In, Ga, Ge, Al, Ce, La, Cs, Zr, Hf, Ti, Bi, Sb, and Zn. When the photoresist film is formed from the photoresist film composition, the formation method may be a spin-coating method or a method of forming the film by a deposition treatment by CVD or ALD.

When the photoresist film (D) is formed by a deposition treatment by CVD or ALD, it is preferable that the photoresist film composition is an EUV-photosensitive metal oxide film and the metal is selected from Sn, Zr, Hf, Ti, Bi, Sb, etc., in particular, Sn, which is excellent in EUV photosensitivity. The metal-oxide-containing film may be a photosensitive organometallic oxide film such as organotin oxide (e.g. haloalkyl Sn, alkoxyalkyl Sn, or amidoalkyl Sn). Specific examples of suitable precursors include trimethyl tin chloride, dimethyltin dichloride, methyltin trichloride, tris(dimethylamino)methyl tin(IV), and (dimethylamino)trimethyl tin(IV).

The metal oxide film may be deposited by PECVD or PEALD, for example, by using a Lam Vector (registered trademark) tool, separating the Sn oxide precursor from O precursor/plasma in the ALD implementation. Deposition temperature is preferably 50°C to 600°C. Deposition pressure is preferably between 100 and 6000 mTorr. Precursor liquid flow rates for metal-oxide-containing film (e.g., an organotin oxide precursor) can be 0.01 to 10 cmm, and gas flow rates (CO₂, CO, Ar, N₂, etc.) can be 100 to 10000 sccm. Plasma powers can be 200 to 1000 W per 300 mm wafer station, using a highfrequency plasma (e.g., 13.56 MHz, 27.1 MHz, or higher). Deposited thickness is preferably 100 to 2000 Å.

### [(2) Step of Forming Resist Pattern]

In this step, a pattern circuit region of the photoresist film (D) is exposed to form an exposed pattern, and then the exposed pattern is developed with a developer to form a resist pattern in the photoresist film (D).

In a positive patterning process, the photoresist film (D) is formed and heat-treated, then exposed, and usually, subjected to alkaline development using an alkaline developer to obtain a positive resist pattern. Furthermore, post-exposure baking (PEB) is preferably performed after the exposure.

As the alkaline developer, an aqueous solution of tetramethylammonium hydroxide (TMAH) or the like can be used.

Meanwhile, in a negative patterning process, the photoresist (D) is formed and heat-treated, then exposed, and usually, subjected to organic solvent development using an organic solvent to obtain a negative resist pattern. Furthermore, PEB is preferably performed after the exposure.

As the organic solvent developer, it is possible to use a developer or the like containing, as a component, one or more selected from 4-methyl-2-pentanol, 2-octanone, 2-nonanone, 2-heptanone, 3-heptanone, 4-heptanone, 2-hexanone, 3-hexanone, diisobutyl ketone, methylcyclohexanone, acetophenone, methylacetophenone, propyl acetate, butyl acetate, isobutyl acetate, amyl acetate, butenyl acetate, isoamyl acetate, propyl formate, butyl formate, isobutyl formate, amyl formate, isoamyl formate, methyl valerate, methyl pentenoate, methyl crotonate, ethyl crotonate, methyl lactate, ethyl lactate, propyl lactate, butyl lactate, isobutyl lactate, amyl lactate, isoamyl lactate, methyl 2-hydroxyisobutyrate, ethyl 2-hydroxyisobutyrate, methyl benzoate, ethyl benzoate, phenyl acetate, benzyl acetate, methyl phenylacetate, benzyl formate, phenylethyl formate, methyl 3-phenylpropionate, benzyl propionate, ethyl phenylacetate, and 2-phenylethyl acetate.

Examples of light for exposure include high-energy beams at wavelengths of 300 nm or less, specifically excimer lasers at 248 nm, 193 nm, and 157 nm, soft X-rays at 3 to 20 nm, an electron beam, X-rays, and the like.

As the method for forming a pattern in the resist upper layer film, it is preferable to use a patterning process using a photolithography with a wavelength of 5 nm or more and 300 nm or less, a direct drawing using an electron beam, nanoimprinting, or a combination thereof.

### [(3) Step of Forming Hard Mask Middle Layer Film Pattern]

In this step, a hard mask middle layer film pattern is formed by etching the silicon-containing antireflective film (C) and the silicon-containing hard mask middle layer film (B) while using the obtained resist pattern as an etching mask.

In this step, for example, the silicon-containing antireflective film (C) (layer C) and the hard mask (B) (layer B) can be processed by dry etching using a fluorine-based gas while using the resist pattern as an etching mask.

### [(4) Step of Forming Organic Underlayer Film Pattern]

In this step, an organic underlayer film pattern is formed by etching the organic underlayer film (A) while using the obtained hard mask middle layer film pattern as an etching mask.

In this step, for example, the organic underlayer film (A) (layer A) can be processed by dry etching using an oxygen-based gas while using the hard mask pattern as an etching mask.

### [(5) Step of Forming Pattern in Substrate to Be Processed]

In this step, the pattern is formed in the substrate to be processed by etching the substrate to be processed while using the obtained organic underlayer film pattern as an etching mask.

In this step, for example, the substrate to be processed can be processed by dry etching using a fluorine-based gas while using the organic underlayer film pattern as an etching mask.

In the present invention, the body to be processed (substrate to be processed) is not particularly limited, and used are substrates made of Si, α-Si, p-Si, SiO₂, SiN, SiON, W, TiN, Al, etc., those in which the layers to be processed are formed on the substrate, and the like. Examples of the layers to be processed include various low-k films such as those made of Si, SiO₂, SiON, SiN, p-Si, α-Si, W, W-Si, Al, Cu, Al-Si, and the like, and stopper films therefor, which can each be typically formed into a thickness of 30 to 10,000 nm, particularly 50 to 5,000 nm. When the layer to be processed is formed, the substrate and the layer to be processed are made of different materials.

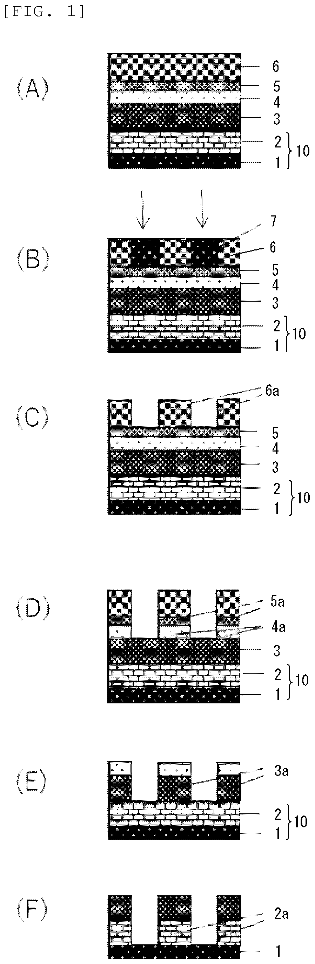

Here, an example of a patterning process according to the above-described three-layer resist process will be described with reference to FIG. 1. In this example, firstly, as in FIG. 1 (A), an organic underlayer film 3 is formed, using an organic underlayer film material, on a layer 2 to be processed of a substrate to be processed 10 including a substrate 1 and the layer 2 to be processed thereon. Then, a silicon-containing hard mask 4 is formed on the organic underlayer film 3. Then, a silicon-containing antireflective film 5 is formed, using a composition for forming a silicon-containing antireflective film, on the silicon-containing hard mask 4. Then, a resist upper layer film 6 is formed, using a photoresist material, on the silicon-containing antireflective film 5. Subsequently, as in FIG. 1 (B), an exposure portion 7 of the photoresist film 6 is subjected to pattern exposure. Then, as in FIG. 1 (C), development with a developer is performed to form a resist pattern 6a in the resist upper layer film. Then, as in FIG. 1 (D), the pattern is transferred to the silicon-containing antireflective film 5 and the silicon-containing hard mask 4 by dry etching while using the resist pattern 6a as a mask to obtain an antireflective film pattern 5a and a hard mask middle layer film pattern 4a. Then, as in FIG. 1 (E), the pattern is transferred to the organic underlayer film 3 by dry etching while using the hard mask middle layer film pattern 4a as a mask to obtain an organic underlayer film pattern 3a. Then, as in FIG. 1 (F), the layer 2 to be processed on the substrate 1 is processed while using the organic underlayer film pattern 3a as a mask to form a pattern 2a in the substrate to be processed 10.

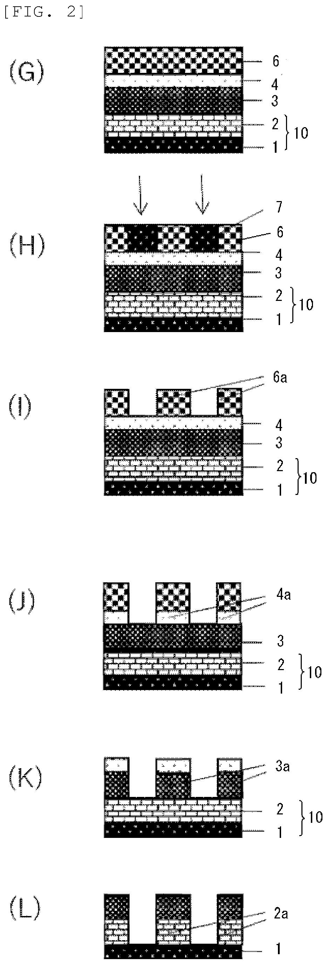

Meanwhile, FIG. 2 is an examples of a patterning process according to a three-layer resist process for a comparative example. The patterning process of the example shown in FIG. 2 is greatly different from the patterning process of the example of FIG. 1 in that a silicon-containing antireflective film is not formed. A three-layer process such as the process shown in FIG. 2 has a problem that it is technically difficult to achieve both higher refraction of the silicon-containing hard mask and dry etching resistance.

### EXAMPLES

In the following, the present invention will be described further specifically with reference to Synthesis Examples, Examples, and Comparative Examples, but the present invention is not limited to these Examples.

### [Synthesis Example] Synthesis of Thermally Crosslinking Polysiloxanes (C1) to (C3)

### (Synthesis Example 1)

Synthesis of Polysiloxane (C1) for Silicon-Containing Antireflective Film

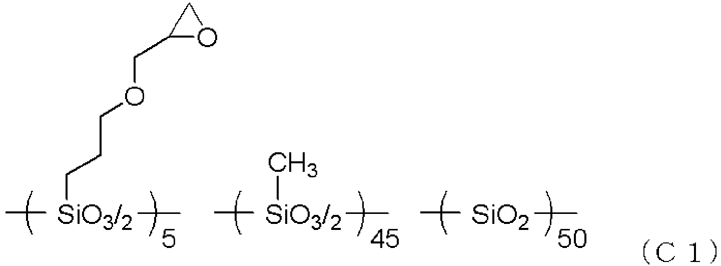

120 g of methanol, 0.1 g of 10% nitric acid, and 60 g of ultrapure water were added together to form a homogeneous solution at 40°C under a nitrogen atmosphere. After that, to the homogeneous solution, a mixture of 38.1 g of tetramethoxysilane, 30.6 g of methyltrimethoxysilane, and 5.9 g of 3-glycidoxypropyltrimethoxysilane was slowly added dropwise. After the addition, a hydrolysis condensation reaction was performed at 40°C for 12 hours. After completion of the reaction, 600 g of PGEE (propylene glycol ethyl ether) was added thereto, and the water and by-produced alcohol were distilled off to collect a polysiloxane compound (C1) as 440 g of a solution in PGEE (compound concentration: 10%). The molecular weight of the polysiloxane compound (C1) was measured in terms of polystyrene, and was Mw=2900.

### (Synthesis Example 2)

Synthesis of Polysiloxane (C2) for Silicon-Containing Antireflective Film

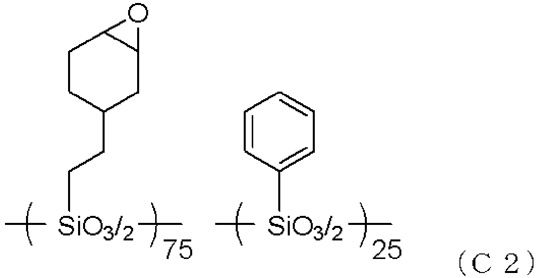

1400 g of ethanol, 700 g of ultrapure water, and 50 g of 25% tetramethylammonium hydroxide were added together to form a homogeneous solution at 40°C under a nitrogen atmosphere. After that, to the homogeneous solution, a mixture of 138.6 g of 2-(3,4-epoxycyclohexyl)ethyltrimethoxysilane and 37.2 g of phenyltrimethoxysilane was slowly added dropwise, and then a reaction was allowed to take place at 40°C for 2 hours. After completion of the reaction, 35 g of acetic acid was added thereto to terminate the reaction, and ethanol was distilled off under reduced pressure. To the solution after the distillation, 2000 ml of ethyl acetate was added to separate the aqueous layer, and the organic layer was washed twice with 400 ml of ultrapure water. Then, 1000 g of PGMEA (propylene glycol monomethyl ether acetate) was added thereto, and the water and low-boiling-point solvent were distilled off to collect a polysiloxane compound (C2) as 600 g of a solution in PGMEA (compound concentration: 20%). The molecular weight of the polysiloxane compound (C2) was measured in terms of polystyrene, and was Mw=2800.

### (Synthesis Example 3)

Synthesis of Polysiloxane (C3) for Silicon-Containing Antireflective Film

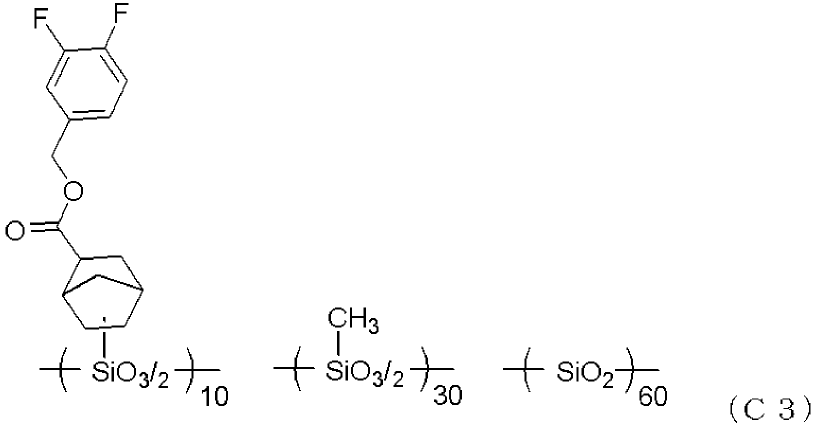

To a mixture of 120 g of methanol, 0.1 g of 10% nitric acid, and 60 g of deionized water, a mixture containing 20.4 g of methyltrimethoxysilane, 45.7 g of tetramethoxysilane, and 20.1 g of a compound of the following (formula C3-1) was added and maintained at 40°C for 12 hours to perform hydrolysis condensation. After completion of the reaction, 500 g of propylene glycol ethyl ether (PGEE) was added thereto, and the water used for the hydrolysis condensation and by-produced alcohol were distilled off under reduced pressure to obtain 450 g of a solution of a polysiloxane compound (C3) in PGEE (compound concentration: 10%). The molecular weight of the polysiloxane compound (C3) was measured in terms of polystyrene, and was Mw=2,200.

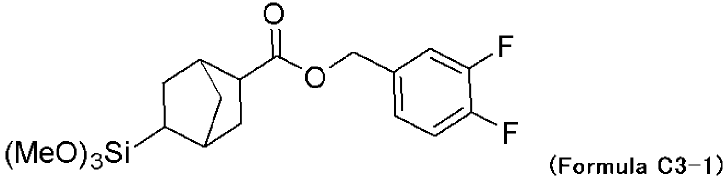

### [Preparation of Compositions for Forming Silicon-Containing Antireflective Film for Examples and Comparative Examples]

The compounds (C1) to (C3) obtained in the Synthesis Examples, crosslinking agents, crosslinking catalysts, acid generators, acid (maleic acid), solvents, and water were mixed at ratios shown in Table 1. Each mixture was filtered through a 0.1-pm filter made of fluorinated resin. Thus, solutions of compositions for forming a silicon-containing antireflective film were prepared and referred to as UDL-1 to UDL-12 and comparative UDL-1.

**[Table 1]**

| Composition | Polysiloxane | | Crosslinking agent | | Crosslinking catalyst | | Acid generator | | Acid Parts by mass | Solvent | | Water |
|---|---|---|---|---|---|---|---|---|---|---|---|---|
| | Type | Parts by mass | Type | Parts by mass | Type | Parts by mass | Type | Parts by mass | | Type | Parts by mass | Parts by mass |
| UDL-1 | (C-1) | 1 | A1 | 0.1 | QBANO₃ | 0.03 | None | None | Maleic acid 0.01 | PGEE | 90 | 10 |
| UDL-2 | (C-1) | 1 | A2 | 0.1 | TPSNO₃ | 0.03 | None | None | Maleic acid 0.01 | PGEE | 90 | 10 |
| UDL-3 | (C-1) | 1 | A3 | 0.1 | TPSNO₃ | 0.03 | None | None | Maleic acid 0.01 | PGEE | 90 | 10 |
| UDL-4 | (C-1) | 1 | A1 | 0.1 | TPSNO₃ | 0.03 | PAG1 | 0.01 | Maleic acid 0.01 | PGEE | 90 | 10 |
| UDL-5 | (C-2) | 10 | A1 | 0.1 | None | None | TAG1 | 0.01 | None | PGMEA | 100 | 0 |
| UDL-6 | (C-2) | 10 | A2 | 0.1 | None | None | TAG1 | 0.01 | None | PGMEA | 100 | 0 |
| UDL-7 | (C-2) | 10 | A3 | 0.1 | None | None | TAG1 | 0.01 | None | PGMEA | 100 | 0 |
| UDL-8 | (C-2) | 10 | A1 | 0.1 | TPSNO₃ | 0.03 | PAG2 | 0.01 | None | PGMEA | 100 | 0 |
| UDL-9 | (C-3) | 10 | A1 | 0.1 | QBANO₃ | 0.03 | None | None | Maleic acid 0.01 | PGEE | 90 | 10 |
| UDL-10 | (C-3) | 10 | A2 | 0.1 | TPSNO₃ | 0.03 | None | None | Maleic acid 0.01 | PGEE | 90 | 10 |
| UDL-11 | (C-3) | 10 | A3 | 0.1 | TPSNO₃ | 0.03 | None | None | Maleic acid 0.01 | PGEE | 90 | 10 |
| UDL-12 | (C-3) | 10 | A1 | 0.1 | TPSNO₃ | 0.03 | PAG3 | 0.01 | Maleic acid 0.01 | PGEE | 90 | 10 |
| Comparative UDL-1 | (C-1) | 10 | None | - | TPSNO₃ | 0.03 | None | - | Maleic acid 0.01 | PGEE | 90 | 10 |

The crosslinking agents used are as follows.

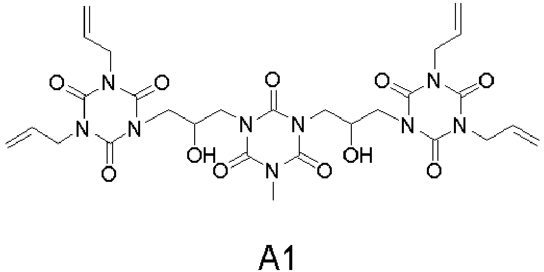

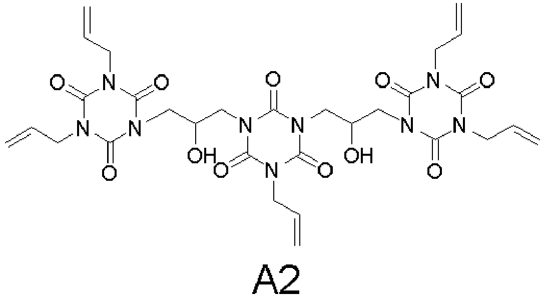

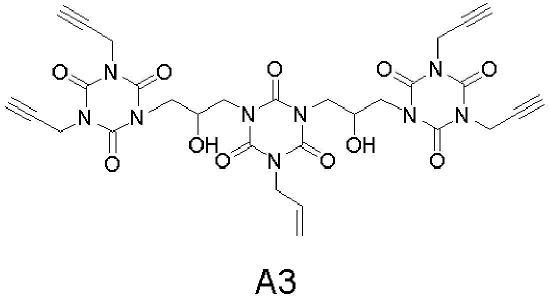

The crosslinking catalysts used are as follows. TPSNO₃···triphenylsulfonium nitrate QBANO₃···tetrabutylammonium nitrate

The solvents used are as follows. PGEE···propylene glycol ethyl ether PGMEA···propylene glycol methyl ether acetate

The used acid generators PAG1 to PAG3 are as shown below in Table 2, and acid generator TAG1 is as shown below.

**[Table 2]**

| PAG | |
|---|---|
| 1 | 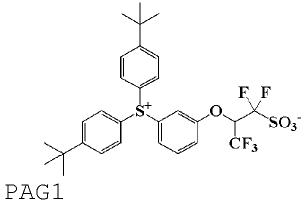 |
| 2 | 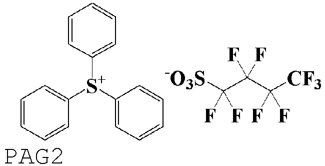 |
| 3 | 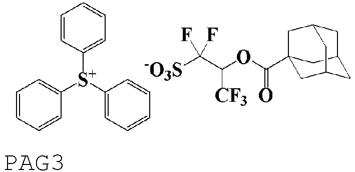 |

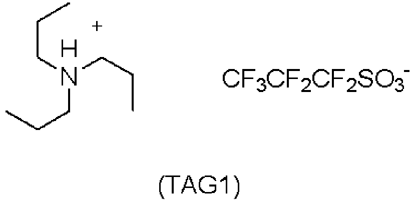

### [Preparation of Compositions for Forming Antireflective Film for Comparative Examples]

As compositions for forming an antireflective film for Comparative Examples, comparative UDL-2 (Table 3) and comparative UDL-3 (Table 4) were used.

As comparative UDL-2, a composition containing the following polymer (P1), thermal acid generator (TAG1), and solvent in the composition shown in Table 3 was used.

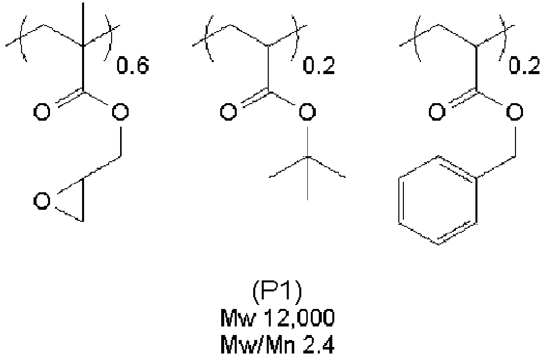

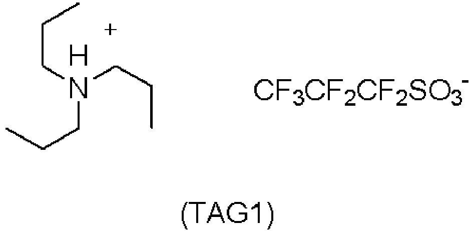

**[Table 3]**

| | Polymer | | Thermal acid generator | | Solvent 1 | | Solvent 2 | |
|---|---|---|---|---|---|---|---|---|
| | Type | Parts by mass | Type | Parts by mass | Type | Parts by mass | Type | Parts by mass |
| Comparative UDL-2 | P1 | 10 | TAG1 | 0.1 | PGMEA | 2240 | PGME | 960 |

As comparative UDL-3, a composition containing the crosslinking agent (A1) and solvent in the composition shown in Table 4 was used.

**[Table 4]**

| | Polymer (Crosslinking agent) | Parts by mass | Solvent 1 | Parts by mass |
|---|---|---|---|---|
| Comparative UDL-3 | A1 | 10 | PGMEA | 2000 |

### [Example 1 and Comparative Example 1: Solvent Resistance Evaluation and Optical Constant Evaluation]

Each of the compositions (UDL-1 to -12 and comparative UDL-1) for forming a silicon-containing antireflective film and compositions (comparative UDL-2 and -3) for forming an antireflective film for Comparative Examples prepared above was respectively applied onto a silicon substrate. The coating film was baked at 220°C for 60 seconds to form an antireflective film, then the film thickness from the center of the substrate to the periphery was measured, and the average film thickness (a [nm]) was calculated. Subsequently, a PGMEA solvent was dispensed thereon, left to stand for 30 seconds, then spin-drying was performed, then the PGMEA was evaporated by baking at 100°C for 60 seconds, and the film thickness (b [nm]) was measured. The difference between the film thicknesses of before and after the PGMEA treatment (film remaining percentage: (b/a) × 100) was calculated.

Meanwhile, each of the compositions (UDL-1 to -12 and comparative UDL-1) for forming a silicon-containing antireflective film and compositions (comparative UDL-2 and -3) for forming an antireflective film for Comparative Examples prepared above was respectively applied onto a silicon substrate. The coating film was baked at 220°C for 60 seconds to form an antireflective film, then the optical constants (refractive index "n" and attenuation coefficient "k") of each antireflective film at a wavelength of 193 nm were determined using a spectroscopic ellipsometer (VASE) with variable angle of incidence manufactured by J. A. Woollam Japan.

In addition, the proportion of the silicon contained in the silicon-containing antireflective films produced above was determined by RBS (Rutherford Backscattering Spectrometry).

The respective results are shown in Table 5 below.

**[Table 5]**

| | C film | Film thickness (a) | Film thickness (b) after PGMEA treatment | Film remaining percentage (b/a × 100) | n | k | Si content |
|---|---|---|---|---|---|---|---|
| | Composition for forming antireflective film | nm | nm | % | 193nm | 193nm | wt% |
| Example 1-1 | UDL-1 | 10.3 | 10.3 | 100% | 1.79 | 0.34 | 25 |
| Example 1-2 | UDL-2 | 10.1 | 10.1 | 100% | 1.8 | 0.35 | 25 |
| Example 1-3 | UDL-3 | 10.1 | 10.1 | 100% | 1.8 | 0.35 | 25 |
| Example 1-4 | UDL-4 | 10.2 | 10.2 | 100% | 1.79 | 0.34 | 25 |
| Example 1-5 | UDL-5 | 10.2 | 10.2 | 100% | 1.82 | 0.34 | 14 |
| Example 1-6 | UDL-6 | 10 | 10 | 100% | 1.82 | 0.35 | 14 |
| Example 1-7 | UDL-7 | 10.3 | 10.3 | 100% | 1.82 | 0.35 | 14 |
| Example 1-8 | UDL-8 | 10.2 | 10.2 | 100% | 1.82 | 0.35 | 14 |
| Example 1-9 | UDL-9 | 9.9 | 9.9 | 100% | 1.8 | 0.33 | 29 |
| Example 1-10 | UDL-10 | 10 | 10 | 100% | 1.8 | 0.34 | 29 |
| Example 1-11 | UDL-11 | 9.8 | 9.8 | 100% | 1.79 | 0.34 | 29 |
| Example 1-12 | UDL-12 | 10 | 10 | 100% | 1.8 | 0.33 | 29 |
| Comparative Example 1-1 | Comparative UDL-1 | 10.1 | 9.9 | 98% | 1.77 | 0.32 | 26 |
| Comparative Example 1-2 | Comparative UDL-2 | 10.4 | 10.4 | 100% | 1.65 | 0.1 | - |
| Comparative Example 1-3 | Comparative UDL-3 | 10.5 | 0 | 0% | 2.1 | 0.45 | - |

In Examples 1-1 to 1-12, where silicon-containing antireflective films to be used in the inventive patterning process were used, the film remaining percentage ((b/a) × 100) after the PGMEA rinsing treatment was more than 99%, and it can be observed that a crosslinking reaction occurred and sufficient solvent resistance was exhibited. On the other hand, in Comparative Example 1-1, where comparative UDL-1, containing no crosslinking agent, was used, solvent resistance was less than 99%, possibly because thermosetting property was somewhat insufficient. Meanwhile, comparative UDL-3, in which the compound A1, used as the crosslinking agent in the silicon-containing antireflective film, was used alone, solvent resistance was 0%, possibly because thermosetting property was insufficient.

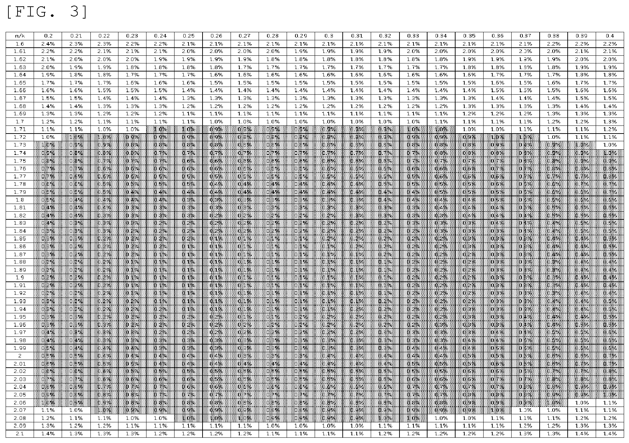

Furthermore, regarding the optical constants of Examples 1-1 to 1-12, where silicon-containing antireflective films to be used in the inventive patterning process were used, the "n" value was between 1.79 and 1.82 and the "k" value was between 0.3 and 0.35 in every case. Regarding the optical constants, although dependent on the film thickness, the types of the laminated films, etc., a considerable amount of light reflected from the substrate in ArF immersion and high-NA exposure can generally be suppressed even in a case where the metal-containing film is formed as a thin film of 10 nm or less when the "n" value is 1.75 to 2.05 and the "k" value is 0.2 to 0.4, and the antireflective film is applicable for photoresist patterning (FIG. 3). In Examples 1-1 to 1-12, the optical constants are in suitable ranges in every case, and it can be observed that the resist underlayer films are applicable to photoresist patterning.

### [Example 2 and Comparative Example 2: ArF Patterning Test]

On a silicon wafer having a 200-nm thick silicon oxide film formed thereon, an amorphous carbon film (ACL, carbon content: 73 atomic%) or an SOC film (ODL-306, carbon content: 61 atomic%) available from Shin-Etsu Chemical Co., Ltd. was formed as an organic underlayer film with a film thickness of 35 nm. Subsequently, on the organic underlayer film, a silicon oxynitride film (SiON) was formed as a silicon-containing hard mask with a film thickness of 15 nm. Furthermore, each of the compositions (UDL-1 to -12 and comparative UDL-1 and -2) for forming an antireflective film was respectively applied onto the SiON film and heated at 220°C for 60 seconds to form an antireflective film with a film thickness of 10 nm.

Subsequently, an ArF resist solution (PR1) for negative development containing the following ArF resist polymer, acid generator, amine quencher, surfactant, and solvents in the composition shown in Table 6 was applied onto the silicon-containing antireflective film and baked at 110°C for 60 seconds to form a resist upper layer film (photoresist film) with a film thickness of 70 nm. Thus, a laminate was obtained.

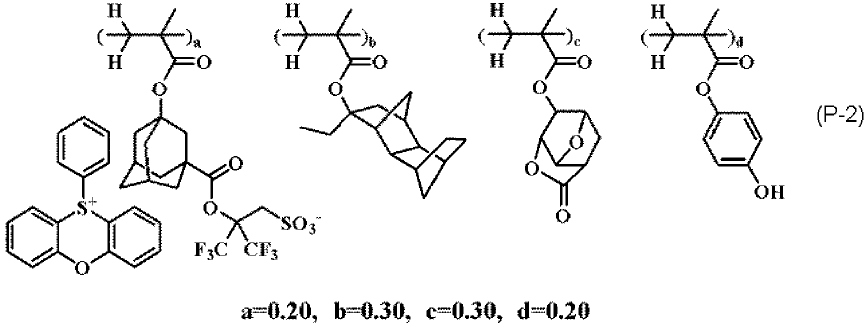

### [Photo-Acid Generator]

(PAG-A): triphenylsulfonium 2-(adamantane-1-carbonyloxy)-1,1,3,3,3-pentafluoropropane-1-sulfonate (compound disclosed in JP2007-145797A)

### [Amine Quencher]

(Q-1): 2-morpholinoethyl laurate

### [Surfactant]

Alkali-soluble surfactant (F-1): poly(3,3,3-trifluoro-2-hydroxy-1,1-dimethyl-2-trifluoromethylpropyl methacrylate/1,1,1-trifluoro-2-hydroxy-6-methyl-2-trifluoro-methylhept-4-yl methacrylate) (compound disclosed in JP2008-122932A)

Weight-average molecular weight (Mw) = 7,300, dispersity (Mw/Mn) = 1.86

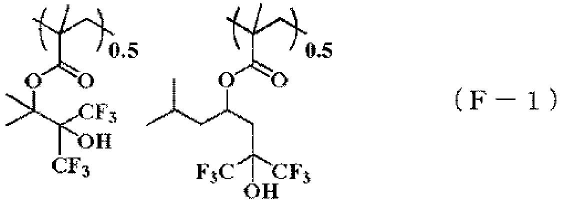

**[Table 6]**

| | Resist polymer | | Photo-acid generator | | Amine quencher | | Surfactant | | Solvent 1 | | Solvent 2 | |
|---|---|---|---|---|---|---|---|---|---|---|---|---|
| | Type | Parts by mass | Type | Parts by mass | Type | Parts by mass | Type | Parts by mass | Type | Parts by mass | Type | Parts by mass |
| RP-1 | P-2 | 80 | PAG-A | 3.8 | Q-1 | 0.6 | F-1 | 5 | PGMEA | 576 | CyHO | 1728 |

### [Organic Solvent]

PGMEA: propylene glycol monomethyl ether acetate

CyHO: cyclohexanone

The photoresist film of the laminate obtained in the above manner was exposed to light with an ArF immersion excimer laser stepper (XT19001 manufactured by ASML, NA: 1.35, σ: 0.98/0.80, cross-pole opening 30 deg., 6% halftone phase shift mask) while using a mask on which a hole pattern was arranged in such a manner that the on-wafer dimensions were a pitch of 90 nm and a width of 36 nm. After the exposure, heat treatment (PEB) was performed for 60 seconds. Then, with a rotation of 30 rpm, butyl acetate was discharged from a developer nozzle for 3 seconds, and then static-puddle-development was performed for 27 seconds. Thus, a negative resist pattern was obtained.

The hole dimensions of the resist pattern produced under the above conditions were measured with an electron microscope (CG5000) manufactured by Hitachi High-Technologies Corporation. Meanwhile, the sectional profile (pattern profile) was observed with an electron microscope (S-4800) manufactured by Hitachi High-Technologies Corporation. When no trailing profile or undercut profile was observed, the evaluation "Good" was given, and when an obvious trailing profile or undercut profile was observed, the evaluation "Poor" was given.

The reflectance was calculated using PROLITH 2020a (Litho Tech Japan Corporation). With the film thickness of the antireflective film fixed to 10 nm, the reflectance at which the "n" of the antireflective film is 1.60 to 2.10 and the "k" is 0.20 to 0.40 was calculated, and the results are shown in FIG. 3. The optical constants (n/k) at which it is possible to reduce the reflected light from the underlying substrate during pattern exposure to 1.0% or less are preferable.

The processing of the antireflective film (layer C) and the silicon-containing hard mask (layer B) was performed by dry etching under the following conditions (1) while using the resist pattern (layer D) as a mask, and then the pattern was transferred to the organic underlayer film (layer A) under the following conditions (2). Finally, the pattern was transferred to the oxide film (substrate to be processed) under the following conditions (3).
(1) Conditions of processing antireflective film (layer C) and silicon-containing hard mask (layer B) Apparatus: dry etching apparatus Telius SP manufactured by Tokyo Electron Limited
   Etching conditions (1):
   Chamber pressure: 80 mT
   RF power (upper): 500 W
   RF power (lower): 300 W
   CF₄ gas flow rate: 150 sccm
   CHF₃ gas flow rate: 50 sccm
   Time: 15 sec
(2) Conditions of processing organic underlayer film (layer A)
   Chamber pressure: 80 mT
   RF power (upper): 500 W
   RF power (lower): 300 W
   CO₂ gas flow rate: 320 sccm
   N₂ gas flow rate: 80 sccm
   Time: 45 sec
(3) Conditions of processing oxide film (substrate to be processed)
   Chamber pressure: 10 mT
   RF power (upper): 100 W
   RF power (lower): 800 W
   CF₄ gas flow rate: 25 sccm
   CHF₃ gas flow rate: 15 sccm
   O₂ gas flow rate: 5 sccm
   Time: 60 sec

The hole dimensions of the pattern produced under the above conditions were measured with an electron microscope (CG5000) manufactured by Hitachi High-Technologies Corporation. In addition, hole diameters of 50 different points within the same exposure shot were measured, and the 3σ value of the dimensional variation was obtained as CDU. The results are shown in Table 7. The smaller the value of CDU, the better and preferable the dimensional control.

**[Table 7]**

| | Layer A | Layer B | Layer C | Layer D | Reflectance | CD after exposure | Pattern profile after exposure | CD after processing | CDU after processing |
|---|---|---|---|---|---|---|---|---|---|
| | Organic underlayer film | Silicon-containing hard mask | Antireflective film | Photoresist film | % | nm | | nm | nm |
| Example 2-1 | ACL | SiON | UDL-1 | PR-1 | 0.5 | 36.4 | Good | 40.4 | 2.1 |
| Example 2-2 | ACL | SiON | UDL-2 | PR-1 | 0.4 | 35.8 | Good | 39.9 | 2 |
| Example 2-3 | ACL | SiON | UDL-3 | PR-1 | 0.4 | 36 | Good | 40.1 | 2.1 |
| Example 2-4 | ACL | SiON | UDL-4 | PR-1 | 0.5 | 36.3 | Good | 40.2 | 2.1 |
| Example 2-5 | ACL | SiON | UDL-5 | PR-1 | 0.3 | 36.1 | Good | 40 | 2 |
| Example 2-6 | ACL | SiON | UDL-6 | PR-1 | 0.4 | 36.3 | Good | 40.2 | 1.8 |
| Example 2-7 | ACL | SiON | UDL-7 | PR-1 | 0.4 | 36 | Good | 39.8 | 2 |
| Example 2-8 | ACL | SiON | UDL-8 | PR-1 | 0.4 | 36.1 | Good | 39.9 | 2 |
| Example 2-9 | ACL | SiON | UDL-9 | PR-1 | 0.4 | 35.9 | Good | 39.7 | 2.2 |
| Example 2-10 | ACL | SiON | UDL-10 | PR-1 | 0.4 | 35.8 | Good | 39.7 | 2.1 |
| Example 2-11 | ACL | SiON | UDL-11 | PR-1 | 0.5 | 35.8 | Good | 39.6 | 2.3 |
| Example 2-12 | ACL | SiON | UDL-12 | PR-1 | 0.4 | 35.7 | Good | 39.7 | 2.2 |
| Example 2-13 | ODL-306 | SiON | UDL-1 | PR-1 | 0.5 | 36.8 | Good | 41.9 | 2.6 |
| Comparative Example 2-1 | ACL | SiON | None | PR-1 | 3.2 | 38.1 | Poor | 44.5 | 4.4 |
| Comparative Example 2-2 | ACL | SiON | Comparative UDL-1 | PR-1 | 0.5 | 37.2 | Poor | 42.2 | 3.2 |
| Comparative Example 2-3 | ACL | SiON | Comparative UDL-2 | PR-1 | 2.6 | 37.7 | Poor | 43.2 | 3.9 |

From the results of Table 7, it was found that in the Examples (Examples 2-1 to 2-13) of the inventive patterning process, the sectional pattern profile after the exposure was excellent and favorable CDU was exhibited after the processing of the substrate to be processed. In particular, Examples 2-1 to 2-12, where an ACL film was used for the organic underlayer film (layer A) exhibited excellent CDU. It is conjectured that the ACL film had better dry etching resistance to the fluorine-based gas during the processing of the substrate to be processed than that of a coating-type organic underlayer film (SOC film), and therefore, excellent pattern transfer property was exhibited.

In Comparative Example 2-1, the sectional pattern profile after the exposure was an undercut profile. This is conjectured to be because basic components generated from the SiON film moved to the photoresist film and the resolution of the resist was degraded, since a silicon-containing antireflective film was not used. Furthermore, it is conjectured that an insufficient effect of suppressing reflected light was also involved in the degradation of the CDU of the resist pattern after exposure, so that the CDU after the processing of the substrate to be processed was also insufficient.

In Comparative Example 2-2, the sectional pattern profile after the exposure was an undercut profile. This is conjectured to be because basic components generated from the SiON film moved to the photoresist film and the resolution of the resist was degraded, since the poisoning-suppression effect of comparative UDL-1 used for the silicon-containing antireflective film was insufficient. From the above results, it can be said that the silicon-containing antireflective film to be used in the present invention is preferably formed using a composition containing the polysiloxane and a crosslinking agent, in order to enhance the density of the film.

In Comparative Example 2-3, the sectional pattern profile after the exposure was an undercut profile. This is conjectured to be because the poisoning-suppression effect of the organic antireflective film (comparative UDL-2) used as the antireflective film was insufficient. Furthermore, it is conjectured that an insufficient effect of suppressing reflected light was also involved in the degradation of the CDU of the resist pattern after exposure, so that the CDU after the processing of the substrate to be processed was also insufficient.

From the above, it can be observed that the inventive patterning process using the silicon-containing antireflective film allows high adhesiveness to a resist pattern and has an effect of suppressing fine pattern collapse, has an excellent antireflective effect and an effect of suppressing poisoning into the photoresist film from the organic underlayer film, and gives a highly rectangular resist upper layer film pattern profile, and therefore, is used particularly suitably in a multilayer resist process, and is extremely useful in fine patterning for semiconductor device production.

The present description includes the following embodiments.
[1] A patterning process comprising the steps of:
   (1) providing (A) an organic underlayer film, (B) a silicon-containing hard mask, (C) a silicon-containing antireflective film, and (D) a photoresist film in this order on a substrate to be processed;
   (2) subjecting a pattern circuit region of the photoresist film (D) to exposure to form an exposed pattern and then developing the exposed pattern with a developer to form a resist pattern in the photoresist film (D);
   (3) forming a hard mask middle layer film pattern by etching the silicon-containing antireflective film (C) and the silicon-containing hard mask (B) while using the obtained resist pattern as an etching mask;
   (4) forming an organic underlayer film pattern by etching the organic underlayer film (A) while using the obtained hard mask middle layer film pattern as an etching mask; and
   (5) forming a pattern in the substrate to be processed by etching the substrate to be processed while using the obtained organic underlayer film pattern as an etching mask,
   wherein the silicon-containing antireflective film (C) is formed using a composition for forming a silicon-containing antireflective film containing a crosslinking agent and a polysiloxane containing any one or more of a repeating unit represented by the following general formula (Sx-1), a repeating unit represented by the following general formula (Sx-2), and a partial structure represented by the following general formula (Sx-3), 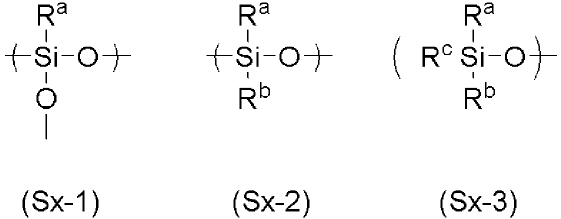 wherein R^{a}, R^{b}, and R^{c} are each identical to or different from each other and represent a monovalent organic group having 1 to 30 carbon atoms.
[2] The patterning process according to [1], wherein, as the silicon-containing hard mask (B), a layer selected from the group consisting of a silicon oxide film, a silicon nitride film, and a silicon oxynitride film is formed.
[3] The patterning process according to [1] or [2], wherein the silicon-containing antireflective film (C) is formed using the polysiloxane, at least one of the R^{a} to R^{c} in the general formulae (Sx-1) to (Sx-3) being an organic group having one or more carbon-oxygen single bonds or carbon-oxygen double bonds.
[4] The patterning process according to any one of [1] to [3], wherein the silicon-containing antireflective film (C) is formed using, as the crosslinking agent, a compound containing an isocyanuric acid structure.
[5] The patterning process according to any one of [1] to [4], wherein the organic underlayer film (A) is formed by a CVD method.
[6] The patterning process according to any one of [1] to [5], wherein, as the organic underlayer film (A), a film including any of a graphene film, an amorphous carbon film, and a diamond-like carbon film is formed.
[7] The patterning process according to any one of [1] to [6], wherein the silicon-containing hard mask (B) and the silicon-containing antireflective film (C) are formed in such a manner that a film thickness FTb of the silicon-containing hard mask (B) and a film thickness FTc of the silicon-containing antireflective film (C) satisfy a relationship FTb > FTc.
[8] The patterning process according to any one of [1] to [7], wherein the silicon-containing antireflective film (C) is formed in such a manner that the silicon-containing antireflective film (C) has a film thickness of 15 nm or less.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A patterning process comprising the steps of:
(1) providing (A) an organic underlayer film, (B) a silicon-containing hard mask, (C) a silicon-containing antireflective film, and (D) a photoresist film in this order on a substrate to be processed;
(2) subjecting a pattern circuit region of the photoresist film (D) to exposure to form an exposed pattern and then developing the exposed pattern with a developer to form a resist pattern in the photoresist film (D);
(3) forming a hard mask middle layer film pattern by etching the silicon-containing antireflective film (C) and the silicon-containing hard mask (B) while using the obtained resist pattern as an etching mask;
(4) forming an organic underlayer film pattern by etching the organic underlayer film (A) while using the obtained hard mask middle layer film pattern as an etching mask; and
(5) forming a pattern in the substrate to be processed by etching the substrate to be processed while using the obtained organic underlayer film pattern as an etching mask,
wherein the silicon-containing antireflective film (C) is formed using a composition for forming a silicon-containing antireflective film containing a crosslinking agent and a polysiloxane containing any one or more of a repeating unit represented by the following general formula (Sx-1), a repeating unit represented by the following general formula (Sx-2), and a partial structure represented by the following general formula (Sx-3), 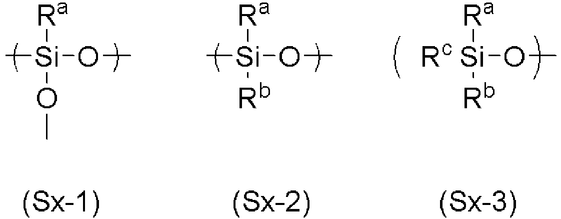
wherein R^{a}, R^{b}, and R^{c} are each identical to or different from each other and represent a monovalent organic group having 1 to 30 carbon atoms.

2. The patterning process according to claim 1, wherein, as the silicon-containing hard mask (B), a layer selected from the group consisting of a silicon oxide film, a silicon nitride film, and a silicon oxynitride film is formed.

3. The patterning process according to claim 1 or 2, wherein the silicon-containing antireflective film (C) is formed using the polysiloxane, at least one of the R^{a} to R^{c} in the general formulae (Sx-1) to (Sx-3) being an organic group having one or more carbon-oxygen single bonds or carbon-oxygen double bonds.

4. The patterning process according to any one of claims 1 to 3, wherein the silicon-containing antireflective film (C) is formed using, as the crosslinking agent, a compound containing an isocyanuric acid structure.

5. The patterning process according to any one of claims 1 to 4, wherein the organic underlayer film (A) is formed by a CVD method.

6. The patterning process according to any one of claims 1 to 5, wherein, as the organic underlayer film (A), a film including any of a graphene film, an amorphous carbon film, and a diamond-like carbon film is formed.

7. The patterning process according to any one of claims 1 to 6, wherein the silicon-containing hard mask (B) and the silicon-containing antireflective film (C) are formed in such a manner that a film thickness FTb of the silicon-containing hard mask (B) and a film thickness FTc of the silicon-containing antireflective film (C) satisfy a relationship FTb > FTc.

8. The patterning process according to any one of claims 1 to 7, wherein the silicon-containing antireflective film (C) is formed in such a manner that the silicon-contai
ning antireflective film (C) has a film thickness of 15 nm or less.
